# EUROPEAN PATENT APPLICATION

(11) **EP 2 393 119 A1**
(43) Date of publication of application: **07.12.2011**
(21) Application number: 10735670.1
(22) Date of filing: 29.01.2010
(51) Int. Cl.: H01L 31/04

(54) **METHOD FOR MANUFACTURING PHOTOELECTRIC CONVERSION DEVICE, PHOTOELECTRIC CONVERSION DEVICE, PHOTOELECTRIC CONVERSION DEVICE MANUFACTURE SYSTEM, AND METHOD FOR UTILIZING PHOTOELECTRIC CONVERSION DEVICE MANUFACTURE SYSTEM**

(30) Priority: 30.01.2009 JP 2009020859
(71) Applicant: ULVAC, INC., Chigasaki-shi Kanagawa 253-8543 (JP)
(72) Inventor: UCHIDA, Hiroto, Chigasaki-shi Kanagawa 253-8543 (JP); FUJINAGA, Tetsushi, Sammu-shi Chiba 289-1226 (JP); WAKAI, Masafumi, Sammu-shi Chiba 289-1226 (JP); KOBAYASHI, Tadamasa, Sammu-shi Chiba 289-1226 (JP); UE, Yoshinobu, Sammu-shi Chiba 289-1226 (JP); NAKAMURA, Kyuzo, Chigasaki-shi Kanagawa 253-8543 (JP); ASARI, Shin, Sammu-shi Chiba 289-1226 (JP); SAITO, Kazuya, Sammu-shi Chiba 289-1226 (JP); MATSUMOTO, Koichi, Chigasaki-shi Kanagawa 253-8543 (JP); SHIMIZU, Yasuo, Chigasaki-shi Kanagawa 253-8543 (JP); MORI, Katsuhiko, Chigasaki-shi Kanagawa 253-8543 (JP)
(74) Representative: Eisenführ, Speiser & Partner
(86) International application number: PCT/JP2010/000547
(87) International publication number: WO 2010/087198

(57) **Abstract**

A photoelectric conversion device manufacturing method manufactures a photoelectric conversion device (10) in which a first photoelectric conversion unit (3) and a second photoelectric conversion unit (4) are sequentially stacked on a transparent-electroconductive film (2) formed on a substrate (1). The method includes: forming each of a first p-type semiconductor layer (31), a first i-type semiconductor layer (32), a first n-type semiconductor layer (33), and a second p-type semiconductor layer (41) in a plurality of first plasma CVD reaction chambers (62, 63, 64, 65); exposing the second p-type semiconductor layer (41) to an air atmosphere; supplying a gas including p-type impurities to inside a second plasma CVD reaction chamber (72) before forming of the second i-type semiconductor layer (42); forming the second i-type semiconductor layer (42) on the second p-type semiconductor layer (41) that was exposed to an air atmosphere, in the second plasma CVD reaction chamber (72); and forming the second n-type semiconductor layer (43) on the second i-type semiconductor layer (42).

## Description

### BACKGROUND OF THE INVENTION

### Field of the Invention

The present invention relates to a photoelectric conversion device manufacturing method, a photoelectric conversion device, a photoelectric conversion device manufacturing system, and a method for using a photoelectric conversion device manufacturing system.

Specifically, the present invention relates to a technique in which a photoelectric conversion device having excellent efficiency can stably manufactured without degradation of characteristics and in which the cost and the efficiency of manufacturing can be improved, even in a case where the number of the processed substrates increases.

This application claims priority from Japanese Patent Application No. 2009-020859 filed on January 30, 2009, the contents of which are incorporated herein by reference in their entirety.

### Background Art

In recent years, the photoelectric conversion devices have been widely used for solar cells, photodetectors, or the like, in particular, in view of efficient use of energy, solar cells are more widely used than ever before.

Specifically, a photoelectric conversion device in which single crystal silicon is utilized has a high level of energy conversion efficiency per unit area.

However, in contrast, in the photoelectric conversion device in which the silicon single crystal is utilized, single crystal silicon ingot is sliced, a sliced silicon wafer is used in the solar cell; therefore, a large amount of energy is spent for manufacturing the ingot, and the manufacturing cost is high.

For example, at the moment, in a case of realizing a photoelectric conversion device having a large area which is placed outdoors or the like, when being manufactured by use of single crystal silicon, the cost considerably increases.

Consequently, as a low-cost photoelectric conversion device, a photoelectric conversion device that can be further inexpensively manufactured and that employs a thin film made of amorphous silicon (hereinafter, refer to "a-Si thin film") is in widespread use.

However, conversion efficiency of a photoelectric conversion device in which an amorphous-silicon thin film is utilized is lower than the conversion efficiency of a crystalline photoelectric conversion device in which single-crystalline silicon, polysilicon, or the like is utilized.

For this reason, as a structure for improving the conversion efficiency of the photoelectric conversion device, a tandem-type structure in which two photoelectric conversion units are stacked in layers has been proposed.

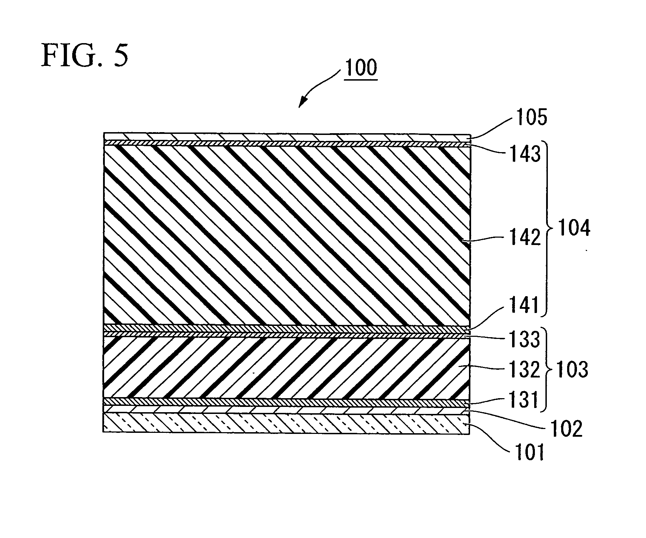

For example, as shown in FIG. 5, a tandem-type photoelectric conversion device 100 is known.

In the photoelectric conversion device 100, a transparent substrate 101 having an insulation property, on which a transparent-electroconductive film 102 is disposed, is employed.

A pin-type first-photoelectric conversion unit 103 that is obtained by stacking a p-type semiconductor layer 131 (p-layer), an i-type silicon layer 132 (amorphous silicon layer, i-layer), and an n-type semiconductor layer 133 (n-layer) in this order is formed on the transparent-electroconductive film 102.

A pin-type second-photoelectric conversion unit 104 that is obtained by stacking a p-type semiconductor layer 141 (p-layer), an i-type silicon layer 142 (crystalline-silicon layer, i-layer), and an n-type semiconductor layer 143 (n-layer) in this order is formed on the first-photoelectric conversion unit 103.

Additionally, a back-face electrode 105 is formed on the second-photoelectric conversion unit 104.

As a method for manufacturing the foregoing tandem-type photoelectric conversion device, a manufacturing method disclosed in Japanese Patent No.3589581 is known.

In the manufacturing method, a plasma CVD reaction chamber is used which corresponds to each of a p-type semiconductor layer, an i-type-amorphous-silicon based photoelectric conversion layer, and an n-type semiconductor layer constituting an amorphous-type photoelectric conversion unit (first photoelectric conversion unit); and one layer is formed in each reaction chamber.

Namely, a plurality of layers are formed by using a plurality of plasma CVD reaction chambers which are different from each other.

Additionally, in the manufacturing method, a p-type semiconductor layer, an i-type-crystalline silicon based photoelectric conversion layer, and an n-type semiconductor layer which constitute a crystalline-type photoelectric conversion unit (second-photoelectric conversion unit) are formed in the same plasma-CVD reaction chamber.

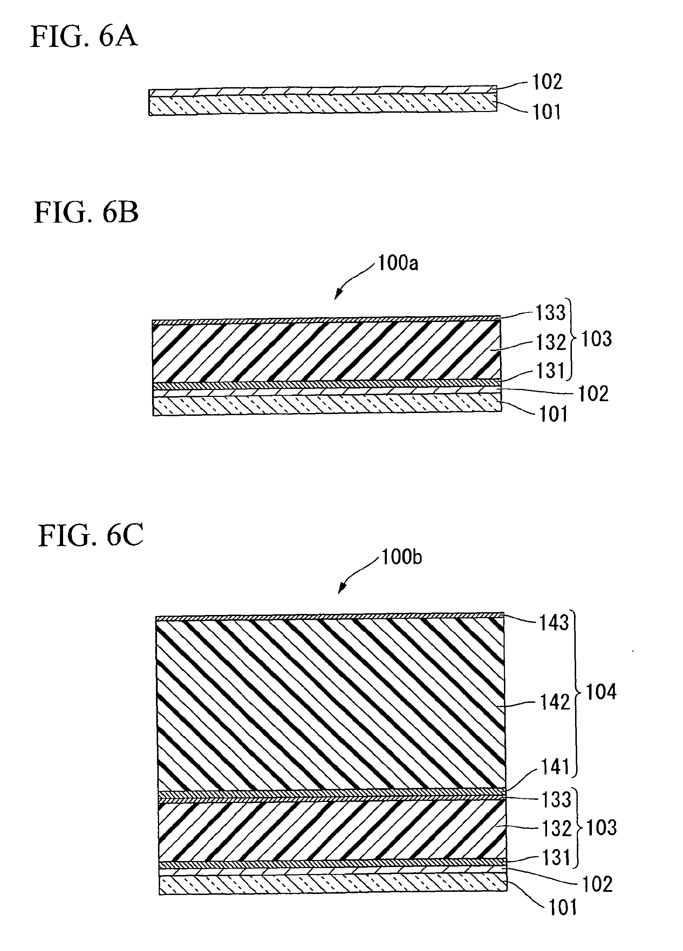

In a method for manufacturing for the tandem-type photoelectric conversion device 100, as shown in FIG. 6A, firstly, an insulative-transparent substrate 101 on which a transparent-electroconductive film 102 is formed is prepared.

Next, as shown in FIG. 6B, a p-type semiconductor layer 131, an i-type silicon layer 132 (amorphous silicon layer), and an n-type semiconductor layer 133 are sequentially formed on the transparent-electroconductive film 102 formed on the insulative-transparent substrate 101.

Here, one of layers 131, 132, and 133 is formed in one plasma CVD reaction chamber.

That is, the layers 131, 132, and 133 are formed by using a plurality of the plasma CVD reaction chambers which are different from each other.

Consequently, a pin-type first-photoelectric conversion unit 103 in which layers are sequentially stacked is formed on the insulative-transparent substrate 101.

Continuously, the n-type semiconductor layer 133 of the first-photoelectric conversion unit 103 is exposed to an air atmosphere and is transferred to a plasma-CVD reaction chamber.

Thereafter, as shown in FIG. 6C, a p-type semiconductor layer 141, an i-type silicon layer 142 (crystalline-silicon layer), and an n-type semiconductor layer 143 are formed in the same plasma-CVD reaction chamber, on the n-type semiconductor layer 133 of the first-photoelectric conversion unit 103 which was exposed to an air atmosphere.

For this reason, a pin-type second-photoelectric conversion unit 104 in which layers are sequentially stacked is formed.

Consequently, due to forming a back-face electrode 105 on the n-type semiconductor layer 143 of the second-photoelectric conversion unit 104, a photoelectric conversion device 100 is obtained as shown in FIG. 5.

The tandem-type photoelectric conversion device 100 composed of the above-described structure are manufactured by the following manufacturing system.

Firstly, in this manufacturing system, a first-photoelectric conversion unit 103 is formed by use of a so-called in-line type first film-formation apparatus in which a plurality of film-formation reaction chambers referred to as chamber are disposed so as to be linearly connected (linear arrangement).

A plurality of the layers constituting the first photoelectric conversion unit 103 are formed in a plurality of film-formation reaction chambers in the first film-formation apparatus.

Namely, one layer constituting the first photoelectric conversion unit 103 is formed in each of a plurality of the film-formation reaction chambers which are different from each other.

After the first-photoelectric conversion unit 103 is formed, a second-photoelectric conversion unit 104 is formed by use of a so-called batch type second film-formation apparatus.

A plurality of layers constituting the second-photoelectric conversion unit 104 is formed in a single film-formation reaction chamber in the second film-formation apparatus.

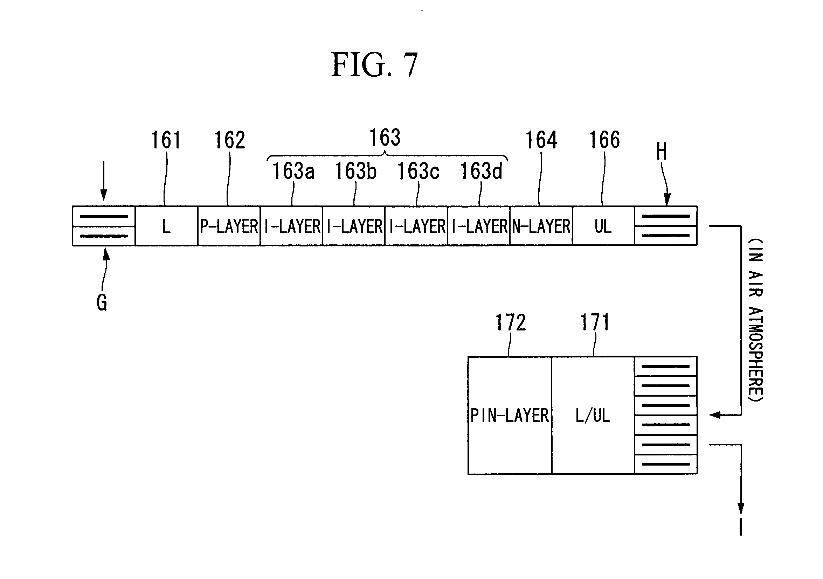

Specifically, the manufacturing system includes a first film-formation apparatus and a second film-formation apparatus as shown in, for example, FIG. 7.

In the first film-formation apparatus, a load chamber 161 (L: Lord), a P-layer film-formation reaction chamber 162, an I-layer film-formation reaction chambers 163, an N-layer film-formation reaction chamber 164, and an unload chamber 166 (UL: Unlord) are continuously and linearly arranged.

In the second film-formation apparatus, a load-unload chamber 171 (L/UL) and a PIN-layer film-formation reaction chamber 172 are arranged.

In the manufacturing system, firstly, a substrate is transferred to the load chamber 161 and is disposed therein, and the internal pressure of the load chamber 161 is reduced.

Continuously, while the reduced-pressure atmosphere being maintained, the p-type semiconductor layer 131 of the first-photoelectric conversion unit 103 is formed in the P-layer film-formation reaction chamber 162, the i-type silicon layer 132 (amorphous silicon layer) is formed in the I-layer film-formation reaction chambers 163, and the n-type semiconductor layer 133 is formed in the N-layer film-formation reaction chamber 164.

The substrate on which the first-photoelectric conversion unit 103 was formed is transferred to the unload chamber 166.

The pressure of the unload chamber 166 is returned from the reduced-pressure to an atmospheric pressure.

The substrate is transferred from the unload chamber 166.

The substrate that was processed in the above-described manner in the first film-formation apparatus, is exposed to an air atmosphere, and is transferred to the second film-formation apparatus.

The substrate on which the first-photoelectric conversion unit 103 was formed is transferred to and disposed in the load-unload chamber 171, and the internal pressure of the load-unload chamber 171 is reduced.

In the load-unload chamber 171, the internal pressure thereof is reduced after the substrate is transferred thereto, and the pressure thereof is returned from the reduced-pressure to an atmospheric pressure when the substrate is transferred from the load-unload chamber 171.

The substrate is transferred to the PIN-layer film-formation reaction chamber 172 via the load-unload chamber 171.

The p-type semiconductor layer 141, the i-type silicon layer 142 (crystalline-silicon layer), and the n-type semiconductor layer 143 of the second-photoelectric conversion unit 104 are sequentially formed on the n-type semiconductor layer 133 of the first-photoelectric conversion unit 103 in the same reaction chamber, that is, in the PIN-layer film-formation reaction chamber 172.

At the G point of the first manufacturing system shown in FIG. 7, the insulative-transparent substrate 101 on which the transparent-electroconductive film 102 is formed is prepared as shown in FIG. 6A.

Additionally, at the H point shown in FIG. 7, a first intermediate part 100a of the photoelectric conversion device in which the first-photoelectric conversion unit 103 is provided is formed on the transparent-electroconductive film 102 formed on the insulative-transparent substrate 101 as shown in FIG. 6B.

Consequently, at the I point shown in FIG. 7, a second intermediate part 100b of the photoelectric conversion device in which the second-photoelectric conversion unit 104 is provided is formed on the first-photoelectric conversion unit 103 as shown in FIG. 6C.

In the in-line type first film-formation apparatus shown in FIG. 7, two substrates are processed at the same time.

The I-layer film-formation reaction chambers 163 are constituted of four reaction chambers 163a to 163d.

Additionally, in the batch type second film-formation apparatus shown in FIG. 7, six substrates are processed at the same time.

In the foregoing conventional manufacturing method, the i-layer that is an amorphous photoelectric conversion layer has a film thickness of 2000 to 3000 Å, and can be manufactured in a reaction chamber for exclusive use.

Furthermore, a reaction chamber for exclusive use is employed for each of the p-layer, the i-layer, and the n-layer.

Because of this, impurities in the p-layer are not diffused in the i-layer, or an indistinct junction which is caused by remaining impurities in the reaction chamber being doped into the p-layer or the n-layer is not generated.

For this reason, an excellent impurity profile in a pin-junction structure is obtained.

On the other hand, the film thickness of the i-layer serving as a crystalline photoelectric conversion layer is required such as 15000 to 25000 Å so as to be one-digit thicker than that of an amorphous photoelectric conversion layer.

Consequently, in order to improve productivity, a batch type reaction chamber is advantageous in which a plurality of substrates is disposed and simultaneously processed.

However, in a case where the p-, i-, and n-layers of the crystalline photoelectric conversion layer are formed in a single reaction chamber, a plurality of films are formed in the same reaction chamber.

For this reason, there is a problem in that an indistinct junction which is caused by impurities in the p-layer being diffused in the i-layer or which is caused by remaining impurities in the reaction chamber being doped into a p-layer and an n-layer is generated.

Additionally, in a thin-film photoelectric conversion device manufacturing method, when a large-scaled substrate is subjected to a film formation processing, it is required that distribution of the crystallization rate of the p-layer, the i-layer, and the n-layer of, particularly, the i-layer of the crystalline photoelectric conversion layer is controlled.

However, in a conventional manufacturing method of forming the p-layer, the i-layer, and the n-layer of the crystalline photoelectric conversion layer (second photoelectric conversion unit) on the n-layer constituting the amorphous photoelectric conversion layer (first photoelectric conversion unit), there is a problem in that variations in distribution of the crystallization rate occurs.

The foregoing variations in distribution of the crystallization rate are influenced by the length of time for leaving or a leaving atmosphere until the second photoelectric conversion unit is formed after the first photoelectric conversion unit is formed.

Furthermore, in a conventional thin-film photoelectric conversion device manufacturing method, after an n-layer constituting a first photoelectric conversion unit is exposed to an air atmosphere, a second photoelectric conversion unit is formed on the n-layer of the first photoelectric conversion unit that was exposed to an air atmosphere.

There is a problem in that the characteristics of the tandem-type thin-film photoelectric conversion device which is manufactured by the above-described manner is degraded as compared with the case of continuously forming all layers thereof while the first photoelectric conversion unit is not exposed to an air atmosphere.

Additionally, in a case where an i-layer and an n-layer constituting the second photoelectric conversion unit are formed on the first photoelectric conversion unit that is exposed to an air atmosphere in a single plasma CVD reaction chamber, n-type impurities are adhered and accumulated inside of the reaction chamber with an increase in the number of the processed substrates.

Due to the influence of n-type impurities accumulated inside of the reaction chamber as described above, there is a problem in that the characteristics of a photoelectric conversion device degrade as the number of the processed substrates increases.

### SUMMARY OF THE INVENTION

The invention was conceived in view of the above-described circumstances and provides a photoelectric conversion device manufacturing method and a manufacturing system therefore, in which variations in distribution of the crystallization rate of a p-layer, an i-layer, and an n-layer constituting a second photoelectric conversion unit, particularly, variations in distribution of the crystallization rate of the i-layer thereof are improved, while impurities in the p-layer constituting the second photoelectric conversion unit are not diffused in the i-layer or an indistinct junction which is caused by impurities remaining in a reaction chamber being doped into the p-layer or the n-layer is not generated.

Additionally, particularly, even where the number of the processed substrates or the number of batches in which a plurality of substrates are integrated increases, the invention provides a photoelectric conversion device manufacturing method and manufacturing system in which it is possible to stably manufacture a photoelectric conversion device having excellent efficiency without degradation of characteristics thereof, and the cost and the efficiency of manufacturing can be improved.

Furthermore, the invention provide a photoelectric conversion device having excellent power generation performance.

The inventors have intensively researched in order to solve the problem in that the characteristics of a photoelectric conversion device is degraded with an increase in the number of the processed substrates as a result from influence of n-type impurities which are accumulated inside of one reaction chamber.

As a result, the inventors have found out that, the n-type impurities generated in one reaction chamber in the manufacturing step of preliminarily manufacturing the second photoelectric conversion unit are doped into the i-layer constituting the second photoelectric conversion unit to be subsequently manufactured at the time of initial growth in the i-layer; for this reason, the characteristics of a photoelectric conversion device are degraded.

Specifically, the inventors have discovered that, when the n-type impurities remaining in the reaction chamber are doped into the i-layer, an interfacial state between the p-layer and the i-layer constituting the second photoelectric conversion unit is different from a desired interfacial state, it is difficult to produce a layered structure formed by the p-layer and the i-layer, and the characteristics of a photoelectric conversion device are degraded.

In view of the above-described circumstances, the inventors have completed the invention.

A photoelectric conversion device manufacturing method of a first aspect of the invention manufactures a photoelectric conversion device in which a first p-type semiconductor layer, a first i-type semiconductor layer, and a first n-type semiconductor layer, which constitute a first photoelectric conversion unit, and a second p-type semiconductor layer, a second i-type semiconductor layer, and a second n-type semiconductor layer, which constitute a second photoelectric conversion unit made of a crystalline-silicon-based thin film, are sequentially stacked in layers on a transparent-electroconductive film formed on a substrate, by use of a plurality of first plasma CVD reaction chambers and a single second plasma CVD reaction chamber.

The photoelectric conversion device manufacturing method of the first aspect of the invention includes: forming each of the first p-type semiconductor layer, the first i-type semiconductor layer, the first n-type semiconductor layer, and the second p-type semiconductor layer in a plurality of the first plasma CVD reaction chambers; exposing the second p-type semiconductor layer to an air atmosphere; supplying a gas including p-type impurities to inside the second plasma CVD reaction chamber before forming of the second i-type semiconductor layer; forming the second i-type semiconductor layer on the second p-type semiconductor layer that was exposed to an air atmosphere, in the second plasma CVD reaction chamber; and forming the second n-type semiconductor layer on the second i-type semiconductor layer.

It is preferable that the photoelectric conversion device manufacturing method of the first aspect of the invention further include forming a third p-type semiconductor layer on the second n-type semiconductor layer in the second plasma CVD reaction chamber.

In the photoelectric conversion device manufacturing method of the first aspect of the invention, it is preferable that the third p-type semiconductor layer include oxygen.

In the photoelectric conversion device manufacturing method of the first aspect of the invention, it is preferable that the third p-type semiconductor layer be formed using a processing gas including a gas having an oxygen element.

A photoelectric conversion device of a second aspect of the invention is manufactured using the above-described photoelectric conversion device manufacturing method.

A manufacturing system of a third aspect of the invention manufactures a photoelectric conversion device in which a first p-type semiconductor layer, a first i-type semiconductor layer, and a first n-type semiconductor layer, which constitute a first photoelectric conversion unit, and a second p-type semiconductor layer, a second i-type semiconductor layer, and a second n-type semiconductor layer, which constitute a second photoelectric conversion unit made of a crystalline-silicon-based thin film, are sequentially stacked in layers on a transparent-electroconductive film formed on a substrate.

The manufacturing system of the third aspect of the invention includes: a first film-formation apparatus including a plurality of first plasma CVD reaction chambers and forming each of the first p-type semiconductor layer, the first i-type semiconductor layer, the first n-type semiconductor layer, and the second p-type semiconductor layer in the first plasma CVD reaction chambers; an exposure apparatus exposing the second p-type semiconductor layer to an air atmosphere; and a second film-formation apparatus including a single second plasma CVD reaction chamber, supplying a gas including p-type impurities to the second plasma CVD reaction chamber before forming of the second i-type semiconductor layer, and forming the second i-type semiconductor layer on the second p-type semiconductor layer that was exposed to an air atmosphere and forming the n-type semiconductor layer on the second i-type semiconductor layer in the second plasma CVD reaction chamber.

In the manufacturing system of the third aspect of the invention, it is preferable that a third p-type semiconductor layer be formed on the second n-type semiconductor layer in the second plasma CVD reaction chamber.

In the manufacturing system of the third aspect of the invention, it is preferable that the third p-type semiconductor layer include oxygen. In the manufacturing system of the third aspect of the invention, it is preferable that the second film-formation apparatus include an oxygen-gas supply section supplying a processing gas including a gas having an oxygen element to the second plasma CVD reaction chamber.

A method for using a photoelectric conversion device manufacturing system of a fourth aspect of the invention, in which the system continuously manufactures photoelectric conversion devices in which a plurality of semiconductor layers including a first-conductivity type semiconductor layer and a second-conductivity type semiconductor layer are stacked in layers on a transparent-electroconductive film formed on a substrate, the method includes: preparing a first film-formation apparatus including a first plasma CVD reaction chamber in which a first-conductivity type semiconductor layer is formed; preparing an exposure apparatus connected to the first film-formation apparatus, exposing the first-conductivity type semiconductor layer formed by the first film-formation apparatus to an air atmosphere; preparing a second film-formation apparatus including a second plasma CVD reaction chamber forming a semiconductor layer different from a first-conductivity type semiconductor layer on the first-conductivity type semiconductor layer that was exposed to an air atmosphere, and the second film-formation apparatus including a transfer device replacing a post-processed substrate on which a plurality of the semiconductor layers are stacked in layers in the second plasma CVD reaction chamber with an unprocessed substrate which is not yet subjected to a film formation processing in the second plasma CVD reaction chamber; supplying a first impurity gas having first conductivity type impurities included in the first-conductivity type semiconductor layer that is exposed to an air atmosphere to the second plasma CVD reaction chamber after the second-conductivity type semiconductor layer is formed in the second plasma CVD reaction chamber and before the unprocessed substrate is transferred to the second plasma CVD reaction chamber; evacuating the first impurity gas from the second plasma CVD reaction chamber after the first impurity gas is supplied to the second plasma CVD reaction chamber; supplying a gas different from the first impurity gas to the second plasma CVD reaction chamber; and forming a semiconductor layer different from the first-conductivity type semiconductor layer.

In the method for using a photoelectric conversion device manufacturing system of the fourth aspect of the invention, it is preferable that the first-conductivity type semiconductor layer be a p-type semiconductor layer including p-type impurities, the second-conductivity type semiconductor layer be an n-type semiconductor layer including n-type impurities, a plurality of semiconductor layers be constituted of a p-type semiconductor layer, an i-type semiconductor layer, and an n-type semiconductor layer, the first impurity gas be a gas including p-type impurities, and the semiconductor layer different from the first-conductivity type semiconductor layer be an i-type semiconductor layer or an n-type semiconductor layer.

In the method for using a photoelectric conversion device manufacturing system of the fourth aspect of the invention, it is preferable that, when the first impurity gas is supplied to the second plasma CVD reaction chamber, plasma of the first impurity gas be generated in the second plasma CVD reaction chamber.

### Effects of the Invention

According to the photoelectric conversion device manufacturing method of the invention, the second i-type semiconductor layer is formed in the second plasma CVD reaction chamber, and the second plasma CVD reaction chamber is different from a plurality of the first plasma CVD reaction chambers in which the first p-type semiconductor layer, the first i-type semiconductor layer, the first n-type semiconductor layer, and the second p-type semiconductor layer are formed.

Because of this, impurities in the p-layer are not diffused in the second i-type semiconductor layer, or it is possible to prevent an indistinct junction which is caused by remaining impurities of the first plasma CVD reaction chamber being doped into a p-layer or an n-layer from being generated.

Additionally, since the second p-type semiconductor layer is exposed to an air atmosphere, an OH is adhered to the surface of the second p-type semiconductor layer, a part of the surface of the second p-type semiconductor layer is oxidized.

For this reason, a crystal core is generated, the crystallization rate of the second i-type semiconductor layer made of a crystalline-silicon-based thin film is improved, the distribution of the crystallization rate can be easily controlled.

Furthermore, according to the photoelectric conversion device manufacturing method of the invention, since the gas including p-type impurities is supplied to the inside of the second plasma CVD reaction chamber before forming of the second i-type semiconductor layer, n-type impurities are prevented from being scattered from the surface of the constituent elements which are disposed in the second plasma CVD reaction chamber (components constituting CVD reaction chamber).

In addition, in this case, a film including p-type impurities may be formed on the surface of the constituent elements which are disposed in the second plasma CVD reaction chamber.

Therefore, n-type impurities are prevented from being scattered in the space of the second plasma CVD reaction chamber before forming of the second i-type semiconductor layer, it is possible to form the second i-type semiconductor layer on the second p-type semiconductor layer without the n-type impurities being doped into the second i-type semiconductor layer.

Because of this, according to the photoelectric conversion device manufacturing method of the invention, impurities in the p-layer are not diffused in the i-layer, or an indistinct junction which is caused by remaining impurities in the reaction chamber being doped into the p-layer or the n-layer is not generated.

Furthermore, variations in distribution of the crystallization rate are improved in the second p-type semiconductor layer, the second i-type semiconductor layer, and the second n-type semiconductor layer, and it is possible to manufacture the second photoelectric conversion unit.

Additionally, according to the photoelectric conversion device manufacturing method of the invention, since the third p-type semiconductor layer is formed on the second n-type semiconductor layer in the second plasma CVD reaction chamber, a film including p-type impurities generated when the third p-type semiconductor layer is formed is adhered to the surface of the constituent elements which are disposed in the second plasma CVD reaction chamber.

For this reason, impurities which are generated in the manufacturing step of preliminarily manufacturing the second photoelectric conversion unit (after a post-processed substrate is obtained) are maintained. That is, the state is maintained where the third p-type semiconductor layer is adhered to the surface of the constituent elements that are disposed in the second plasma CVD reaction chamber.

In this state, at the time of initial growth in the second i-type semiconductor layer to be subsequently manufactured (at the time of forming a second i-type semiconductor layer on an unprocessed substrate), p-type impurities which are generated along with formation of the third p-type semiconductor layer are only doped into the interface between the second p-type semiconductor layer and the second i-type semiconductor layer.

When a layered structure formed by the second p-type semiconductor layer and the second i-type semiconductor layer of the second photoelectric conversion unit is formed, the p-type impurities expedite formation of a desired and normal p-i interface without inhibiting the junction state of a p-i interface.

As a result, even where a step of transferring a substrate to or from the second plasma CVD reaction chamber and a step of forming a film on the substrate in the second plasma CVD reaction chamber are performed a plurality of times, that is, even where the number of the processed substrates or the number of batches in which a plurality of substrates are integrated increases, the characteristics of a photoelectric conversion device are not degraded.

Because of this, it is possible to stably manufacture a photoelectric conversion device having excellent efficiency, and the cost and the efficiency of manufacturing can be improved.

According to the photoelectric conversion device of the invention, since the photoelectric conversion device is formed by the above-described manufacturing method, it is possible to reliably obtain impurity profile of pin, an indistinct junction is not generated, further, a photoelectric conversion device having distribution of the crystallization rate without irregularity is obtained.

Specifically, when a layered structure formed by the second p-type semiconductor layer and the second i-type semiconductor layer of the second photoelectric conversion unit is manufactured, a desired and normal p-i interface is formed without inhibiting the junction state of a p-i interface.

As a result, it is possible to obtain a thin-film photoelectric conversion device having excellent efficiency.

According to the photoelectric conversion device of the invention manufacturing system, the photoelectric conversion device including the first photoelectric conversion unit and the second photoelectric conversion unit is manufactured using the first film-formation apparatus, the exposure apparatus, and the second film-formation apparatus.

Because of this, the second p-type semiconductor layer is formed in the second plasma CVD reaction chamber different from a plurality of first plasma CVD reaction chambers in which the first p-type semiconductor layer, the first i-type semiconductor layer, the first n-type semiconductor layer, and the second i-type semiconductor layer are formed.

For this reason, impurities in the p-layer are not diffused in the second i-type semiconductor layer, or generation of an indistinct junction which is caused by remaining impurities of the first plasma CVD reaction chamber being doped into the p-layer or the n-layer can be prevented.

Furthermore, it is possible to manufacture a photoelectric conversion device in which variations in distribution of the crystallization rate are improved in the second p-type semiconductor layer, the second i-type semiconductor layer, and the second n-type semiconductor layer, particularly, in the second i-type semiconductor layer.

Moreover, according to the photoelectric conversion device of the invention manufacturing system, since the gas including p-type impurities is supplied to the inside of the second plasma CVD reaction chamber before forming of the second i-type semiconductor layer, n-type impurities are prevented from being scattered from the surface of the constituent elements which are disposed in the second plasma CVD reaction chamber.

In addition, in this case, a film including p-type impurities may be formed on the surface of the constituent elements which are disposed in the second plasma CVD reaction chamber.

Therefore, n-type impurities are prevented from being scattered in the space of the second plasma CVD reaction chamber before forming of the second i-type semiconductor layer, it is possible to form the second i-type semiconductor layer on the second p-type semiconductor layer without the n-type impurities being doped into the second i-type semiconductor layer.

Additionally, according to the photoelectric conversion device manufacturing method of the invention, since the third p-type semiconductor layer is formed on the second n-type semiconductor layer in the second plasma CVD reaction chamber, a film including p-type impurities generated when the third p-type semiconductor layer is formed is adhered to the surface of the constituent elements which are disposed in the second plasma CVD reaction chamber.

For this reason, impurities which are generated in the manufacturing step of preliminarily manufacturing the second photoelectric conversion unit are maintained, that is, the state is maintained where the third p-type semiconductor layer are adhered to the surface of the constituent elements are disposed in the second plasma CVD reaction chamber.

In this state, at the time of initial growth in the second i-type semiconductor layer to be subsequently manufactured, p-type impurities which are generated along with formation of the third p-type semiconductor layer are only doped into the interface between the second p-type semiconductor layer and the second i-type semiconductor layer.

When a layered structure formed by the second p-type semiconductor layer and the second i-type semiconductor layer of the second photoelectric conversion unit is formed, the p-type impurities expedite formation of a desired and normal p-i interface without inhibiting the junction state of a p-i interface.

As a result, even where a step of transferring a substrate to or from the second plasma CVD reaction chamber and a step of forming a film on the substrate in the second plasma CVD reaction chamber are performed a plurality of times, that is, even where the number of the processed substrates or the number of batches in which a plurality of substrates are integrated increases, the characteristics of a photoelectric conversion device are not degraded.

Because of this, it is possible to stably manufacture a photoelectric conversion device having excellent efficiency, and the cost and the efficiency of manufacturing can be improved.

Additionally, when the third p-type semiconductor layer including oxygen is formed, the oxygen-gas supply section can be used.

Furthermore, according to the method for using a photoelectric conversion device manufacturing system of the fourth aspect of the invention, the same effects as the above-described photoelectric conversion device manufacturing method and the manufacturing system therefor are obtained.

### BRIEF DESCRIPTION OF THE DRAWINGS

FIG. 1A is a cross-sectional view illustrating a photoelectric conversion device manufacturing method related to the invention.
FIG. 1B is a cross-sectional view illustrating the photoelectric conversion device manufacturing method related to the invention.
FIG. 1C is a cross-sectional view illustrating the photoelectric conversion device manufacturing method related to the invention.
FIG. 2 is a cross-sectional view showing a layer structure of a photoelectric conversion device related to the invention.
FIG. 3 is a schematic diagram showing a manufacturing system related to the invention which manufactures a photoelectric conversion device.
FIG. 4 is a cross-sectional view showing a layer structure of a photoelectric conversion device related to the invention.
FIG. 5 is a cross-sectional view showing a conventional photoelectric conversion device.
FIG. 6A is a cross-sectional view illustrating a conventional photoelectric conversion device manufacturing method.
FIG. 6B is a cross-sectional view illustrating a conventional photoelectric conversion device manufacturing method.
FIG. 6C is a cross-sectional view illustrating a conventional photoelectric conversion device manufacturing method.
FIG. 7 is a schematic diagram showing a conventional manufacturing system which manufacture a photoelectric conversion device.

### DESCRIPTION OF THE PREFERRED EMBODIMENTS

Next, embodiments of the invention will be described with reference to drawings.

In the embodiments described below, a photoelectric conversion device manufacturing method, a photoelectric conversion device, a photoelectric conversion device manufacturing system, and a method for using the photoelectric conversion device manufacturing system, which are related to the invention, will be described with reference to drawings.

In the photoelectric conversion device, an amorphous silicon photoelectric conversion device serving as the first photoelectric conversion unit and a microcrystalline silicon photoelectric conversion device serving as the second photoelectric conversion unit are stacked in layers.

Additionally, in the respective drawings used in the below explanation, in order to make the respective components be of understandable size in the drawing, the dimensions and the proportions of the respective components are modified as needed compared with the real components.

Moreover, in explanation described below, a first conductivity type represents a p-type, and a second conductivity type represents an n-type.

### First Embodiment

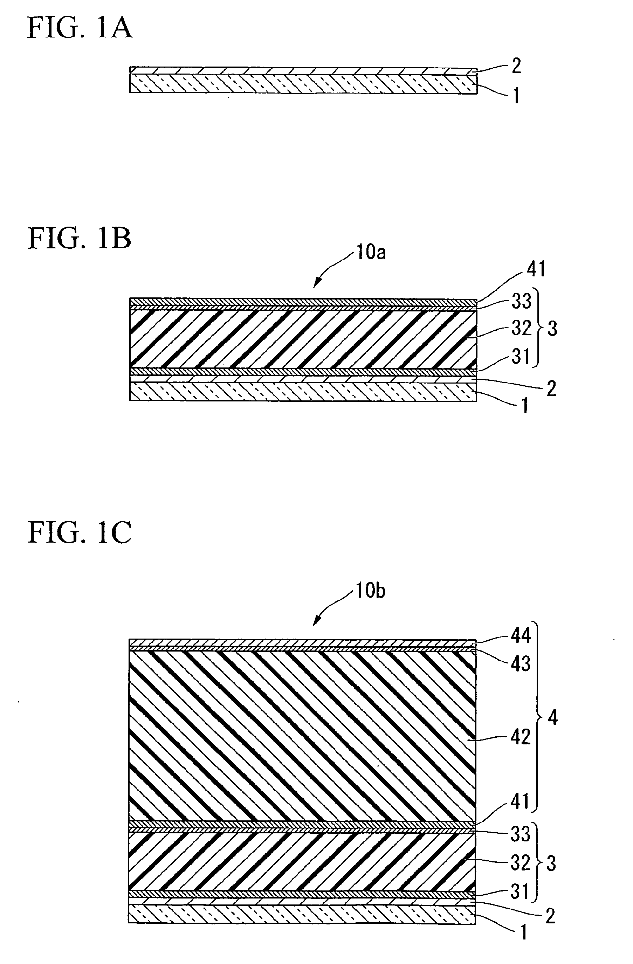

FIGS. 1A to 1C are cross-sectional views illustrating a photoelectric conversion device manufacturing method of the invention.

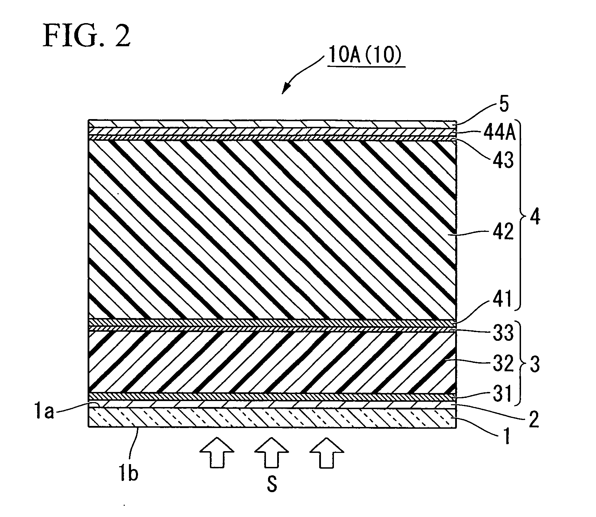

FIG. 2 is a cross-sectional view showing the layer structure of a photoelectric conversion device manufactured by the invention.

Firstly, as shown in FIG. 2, in the photoelectric conversion device 10A (10) manufactured by the manufacturing method of the invention, a first photoelectric conversion unit 3 and a second photoelectric conversion unit 4 are formed on a first face 1a (top face) of a substrate 1 in this order and stacked in layers.

Furthermore, a back-face electrode 5 is formed above the second photoelectric conversion unit 4.

Each of the first photoelectric conversion unit 3 and the second photoelectric conversion unit 4 includes a pin-type layer structure.

The substrate 1 is a substrate having optical transparency and insulation property and is composed of an insulation material having an excellent sunlight transparency and durability such as a glass, a transparent resin, or the like.

The substrate 1 is provided with a transparent-electroconductive film 2.

An oxide of metal having optical transparency such as ITO (Indium Tin Oxide), SnO₂, ZnO, or the like is adopted as the material of the transparent-electroconductive film 2.

The transparent-electroconductive film 2 is formed on the substrate 1 using a vacuum deposition method or a sputtering method.

In the photoelectric conversion device 10, as indicated by the arrow of FIG. 2, sunlight S is incident to a second face 1b of the substrate 1.

Additionally, the first photoelectric conversion unit 3 has a pin structure in which a p-type semiconductor layer 31 (a p-layer, a first p-type semiconductor layer, or a first-conductivity type semiconductor layer), substantially intrinsic i-type semiconductor layer 32 (an amorphous silicon layer, an i-layer, or a first i-type semiconductor layer), and an n-type semiconductor layer 33 (an n-layer, a first n-type semiconductor layer, or a second-conductivity type semiconductor layer) are stacked in layers.

That is, the first photoelectric conversion unit 3 is formed by stacking the p-layer 31, the i-layer 32, and the n-layer 33 in this order.

The first photoelectric conversion unit 3 is constituted of an amorphous silicon based material.

In the first photoelectric conversion unit 3, the thickness of the p-layer 31 is, for example, 90 Å, the thickness of the i-layer 32 is, for example, 2500 Å, and the thickness of the n-layer 33 is, for example, 300 Å.

The p-layer 31, the i-layer 32, and the n-layer 33 of the first photoelectric conversion unit 3 are formed in a plurality of plasma CVD reaction chambers (first plasma CVD reaction chamber).

That is, in each of the plasma CVD reaction chambers which are different from each other, one layer constituting the first photoelectric conversion unit 103 is formed.

Additionally, the second photoelectric conversion unit 4 has a pin structure in which a p-type semiconductor layer 41 (a p-layer, a second p-type semiconductor layer, or a first-conductivity type semiconductor layer), substantially intrinsic i-type semiconductor layer 42 (a crystalline-silicon layer, an i-layer, or a second i-type semiconductor layer), and an n-type semiconductor layer 43 (an n-layer, a second n-type semiconductor layer, or a second-conductivity type semiconductor layer) are stacked in layers.

Furthermore, in the second photoelectric conversion unit 4, a p-type semiconductor layer 44A (p-layer, third p-type semiconductor layer) is formed on the n-layer 43.

That is, the second photoelectric conversion unit 4 is formed by stacking the p-layer 41, the i-layer 42, the n-layer 43, and the p-layer 44A in this order.

The second photoelectric conversion unit 4 is constituted of a silicon based material including a crystalline material.

In the second photoelectric conversion unit 4, the thickness of the p-layer 41 is, for example, 100 Å, the thickness of the i-layer 42 is, for example, 15000 Å, and the thickness of the n-layer 43 is, for example, 150 Å.

Relating to the plasma CVD reaction chamber in which the second photoelectric conversion unit 4 is formed, the plasma CVD reaction chamber (first plasma CVD reaction chamber) in which the p-layer 41 is formed is different from the plasma CVD reaction chamber (second plasma CVD reaction chamber) in which the i-layer 42 and the n-layer 43 are formed.

The i-layer 42 and the n-layer 43 are formed in the same plasma CVD reaction chamber (single second plasma CVD reaction chamber).

Specifically, in the second photoelectric conversion unit 4 of the photoelectric conversion device 10A (10) of the first embodiment, the p-layer 44A is formed on the n-type semiconductor layer 43 (n-layer).

The p-layer 44A is constituted of a silicon based material including a crystalline material.

Additionally, the thickness of the p-layer 44A is, for example, 50 Å.

As specifically described below, the p-layer 44A is formed in the same plasma CVD reaction chamber as the plasma CVD reaction chamber (single second plasma CVD reaction chamber) in which the i-layer 42 and the n-layer 43 of the second photoelectric conversion unit 4 are formed.

The back-face electrode 5 is formed of a light reflection film having conductivity such as Ag (silver), A1 (aluminum), or the like.

The back-face electrode 5 is formed using, for example, a sputtering method or an evaporation method.

Additionally, as the structure of the back-face electrode 5, a layered structure may be adopted in which a film composed of a conductive oxidative product such as ITO, SnO₂, ZnO, or the like is formed between the p-layer 44A and the back-face electrode 5 of the second photoelectric conversion unit 4.

Next, a method for manufacturing a photoelectric conversion device 10A (10) having the above-described constitution will be described.

Firstly, as shown in FIG. 1A, an insulative-transparent substrate 1 on which a transparent-electroconductive film 2 is formed is prepared.

Next, as shown in FIG. 1B, a p-layer 31, an i-layer 32, an n-layer 33, and a p-layer 41 are formed above the transparent-electroconductive film 2 formed on the insulative-transparent substrate 1.

Here, a plurality of the plasma CVD reaction chambers (first plasma CVD reaction chamber) in which the p-layer 31, the i-layer 32, the n-layer 33, and the p-layer 41 are formed are different from each other.

In addition, one of the p-layer 31, the i-layer 32, the n-layer 33, and the p-layer 41 is formed in one plasma CVD reaction chamber, and the p-layer 31, the i-layer 32, the n-layer 33, and the p-layer 41 are subsequently formed in a plurality of the plasma CVD reaction chambers which are connected in line.

That is, a first intermediate part 10a of the photoelectric conversion device in which the p-layer 41 constituting the second photoelectric conversion unit 4 is provided on the n-layer 33 of the first photoelectric conversion unit 3 is obtained.

The p-layer 31 is formed in an individual reaction chamber using a plasma CVD method.

The p-layer 31 composed of amorphous silicon (a-Si) can be formed under conditions in which, for example, the substrate temperature is 180 to 200°C, the frequency of the power source is 13.56 MHz, the internal pressure of the reaction chamber is 70 to 120 Pa, and the flow rates of the reactive gases are 300 sccm of monosilane (SiH₄), 2300 sccm of hydrogen (H₂), 180 sccm of diborane (B₂H₆/H₂) using hydrogen as a diluted gas, and 500 sccm of methane (CH₄).

The i-layer 32 (amorphous silicon layer) is formed in an individual reaction chamber using a plasma CVD method.

The i-layer 32 composed of amorphous silicon can be formed under conditions in which, for example, the substrate temperature is 180 to 200°C, the frequency of the power source is 13.56 MHz, the internal pressure of the reaction chamber is 70 to 120 Pa, and the flow rate of the reactive gas is 1200 sccm of monosilane (SiH₄).

The n-layer 33 is formed in an individual reaction chamber using a plasma CVD method.

The n-layer composed of amorphous silicon can be formed under conditions in which, for example, the substrate temperature is 180 to 200°C, the frequency of the power source is 13.56 MHz, the internal pressure of the reaction chamber is 70 to 120 Pa, and the flow rate of the reactive gas is 200 sccm of phosphine (PH₃/H₂) using hydrogen as a diluted gas.

The p-layer 41 is formed in an individual reaction chamber using a plasma CVD method.

The p-layer composed of microcrystalline silicon can be formed under conditions in which, for example, the substrate temperature is 180 to 200°C, the frequency of the power source is 13.56 MHz, the internal pressure of the reaction chamber is 500 to 900 Pa, and the flow rates of the reactive gases are 100 sccm of monosilane (SiH₄), 25000 sccm of hydrogen (H₂), and 50 sccm of diborane (B₂H₆/H₂) using hydrogen as a diluted gas.

Subsequently, the substrate 1 on which the p-layer 31, the i-layer 32, the n-layer 33, and the p-layer 41 are formed in the above-described manner is removed from the reaction chamber, the p-layer 41 is exposed to an air atmosphere, and the substrate is transferred to a single second plasma CVD reaction chamber.

As shown in FIG. 1C, an i-layer 42, an n-layer 43, and a p-layer 44A which constitute the second photoelectric conversion unit 4 are formed on the p-layer 41 that was exposed to an air atmosphere in the same plasma CVD reaction chamber (single second plasma CVD reaction chamber).

That is, a second intermediate part 10b of the photoelectric conversion device in which the second photoelectric conversion unit 4 is provided on the first photoelectric conversion unit 3 is obtained.

Thereafter, due to forming the back-face electrode 5 on the second photoelectric conversion unit 4, the photoelectric conversion device 10A (10) is obtained as shown in FIG. 2.

The i-layer 42 is formed in the same reaction chamber as the reaction chamber in which the n-layer 43 is formed.

The i-layer composed of microcrystalline silicon (µc-Si) can be formed under conditions in which, for example, the substrate temperature is 180 to 200°C, the frequency of the power source is 13.56 MHz, the internal pressure of the reaction chamber is 500 to 900 Pa, and the flow rates of the reactive gases are 180 sccm of monosilane (SiH₄) and 27000 sccm of hydrogen (H₂).

The n-layer 43 is formed in the same reaction chamber as the reaction chamber in which the i-layer 42 is formed.

The n-layer composed of microcrystalline silicon can be formed under conditions in which, for example, the substrate temperature is 180 to 200°C, the frequency of the power source is 13.56 MHz, the internal pressure of the reaction chamber is 500 to 900 Pa, and the flow rates of the reactive gases are 180 sccm of monosilane (SiH₄), 27000 sccm of hydrogen (H₂), and 200 sccm of phosphine (PH₃/H₂) using hydrogen as a diluted gas.

The p-layer 44A is formed in the same reaction chamber as the reaction chamber in which the i-layer 42 and the n-layer 43 which constitute the second photoelectric conversion unit 4 are formed.

The p-layer composed of microcrystalline silicon can be formed under conditions in which, for example, the substrate temperature is 180 to 200°C, the frequency of the power source is 13.56 MHz, the internal pressure of the reaction chamber is 500 to 900 Pa, and the flow rates of the reactive gases are 100 sccm of monosilane (SiH₄), 25000 sccm of hydrogen (H₂), and 50 sccm of diborane (B₂H₆/H₂) using hydrogen as a diluted gas.

In this process, diborane corresponds to a first impurity gas of the invention.

Additionally, the compositions of gases which are used at the time of forming the p-layer 44A may be the same as or different from the compositions of gases which are to be supplied to the second plasma CVD reaction chamber before forming of the i-layer 42 as described below.

Furthermore, the gas is not limited to diborane; as a first impurity gas, a gas including p-type impurities is used.

In the first embodiment as described above, the p-layer 44A is formed on the n-layer 43 in the same plasma CVD reaction chamber in which the i-layer 42 and the n-layer 43 are formed.

Additionally, among a plurality of layers constituting the second photoelectric conversion unit 4, the p-layer 44A is a layer which is finally formed in the second plasma CVD reaction chamber.

That is, even where the second photoelectric conversion unit 4 is transferred from the second plasma CVD reaction chamber after the p-layer 44A is formed, p-type impurities (first conductivity type impurities) forming the p-layer 44A remains in the second plasma CVD reaction chamber.

Consequently, p-type impurities (p-layer) are adhered to on the surface of the constituent elements (components constituting the second CVD reaction chamber) which are disposed in the second CVD reaction chamber.

Because of this, the p-layer 41 is formed in a state where p-type impurities (p-layer) remain in the second plasma CVD reaction chamber.

Here, the components constituting the second CVD reaction chamber mean electrodes to which a high-frequency voltage is to be supplied, a shower plate, a wall portion of the chamber, a substrate heating mechanism, a substrate mounting table, or a substrate transfer mechanism including a carrier or the like.

Next, more specifically, a film formation step in the second plasma CVD reaction chamber will be described.

An unprocessed substrate on which an i-layer 42, an n-layer 43, and a p-layer 44A are not formed is transferred to the second plasma CVD reaction chamber.

Subsequently, an i-layer 42, an n-layer 43, and a p-layer 44A are formed on the substrate.

Furthermore, a post-processed substrate on which the films are formed in the above-described manner is transferred from the second plasma CVD reaction chamber.

Thereafter, the unprocessed substrate is transferred to the second plasma CVD reaction chamber, and a plurality of layers are formed on the substrate as described above.

Even where the foregoing sequence of transfer and film formation steps is repeated, since the p-type impurities (p-layer) generated in a prior film formation step (first film formation step) remain in the second plasma CVD reaction chamber, the p-type impurities (p-layer) remain in a film formation step (second film formation step) which is afterward performed, and the p-layer 41 is formed in the above state.

That is, even where the unprocessed substrate is replaced with the post-processed substrate, the p-layer 41 is formed in a state where p-type impurities (p-layer) remain in the second plasma CVD reaction chamber.

In other words, in the aforementioned film formation step, a gas including p-type impurities is supplied to the inside of the second plasma CVD reaction chamber before forming of the i-layer 42.

Additionally, in this case, not only supplying the gas including p-type impurities but also plasma made of the gas including p-type impurities are generated in the second plasma CVD reaction chamber, and a film including p-type impurities is formed on the surface of the constituent elements.

For this reason, n-type impurities (second conductivity type impurities) are prevented from being scattered from the surface of the constituent elements which are disposed in the second plasma CVD reaction chamber.

Here, the p-type impurities in the above-described film formation step will be specifically described.

In the second plasma CVD reaction chamber, since the p-layer 44A is formed on the n-layer 43, a film including p-type impurities generated when the p-layer 44A is formed is adhered to the surface of the constituent elements are disposed in the second plasma CVD reaction chamber.

For this reason, impurities which are generated in the manufacturing step of preliminarily manufacturing the second photoelectric conversion unit are maintained, that is, the state is maintained where the p-layer 44A are adhered to the surface of the constituent elements are disposed in the second plasma CVD reaction chamber.

In this state, at the time of initial growth in the i-layer 42 to be subsequently manufactured, p-type impurities which are generated along with formation of the p-layer 44A are only doped into the interface between the p-layer 41 and the i-layer 42.

When a layered structure formed by the p-layer 41 and the i-layer 42 of the second photoelectric conversion unit is formed, the p-type impurities expedite formation of a desired and normal p-i interface without inhibiting the junction state of a p-i interface.

Because of this, it is possible to prevent the characteristics of a photoelectric conversion device from being degraded.

As a result, the photoelectric conversion device 10A (10) which is manufactured in the above-described manner has excellent efficiency.

Therefore, even where a step of transferring a substrate to or from the second plasma CVD reaction chamber and a step of forming a film on the substrate in the second plasma CVD reaction chamber are performed a plurality of times, that is, even where the number of the processed substrates or the number of batches in which a plurality of substrates are integrated increases, the characteristics of a photoelectric conversion device are not degraded.

Because of this, it is possible to stably manufacture a photoelectric conversion device having excellent efficiency, and the cost and the efficiency of manufacturing can be improved.

Next, a system manufacturing the photoelectric conversion device 10A (10) will be described with reference to drawings.

A photoelectric conversion device manufacturing system of the first embodiment has a structure in which a so-called in-line type first film-formation apparatus, an exposure apparatus in which the second p-type semiconductor layer is exposed to an air atmosphere, and a so-called batch type second film-formation apparatus are arranged in order.

The in-line type first-film-formation apparatus has a structure in which a plurality of film-formation reaction chambers (first plasma CVD reaction chamber) referred to as chamber are disposed so as to be linearly connected.

In the first film-formation apparatus, each of layers, that is, the p-layer 31, the i-layer 32, and the n-layer 33 of the first photoelectric conversion unit 3, and the p-layer 41 of the second photoelectric conversion unit 4, is separately formed.

Since the film-formation reaction chambers are connected in line, four layers including the p-layer 31, the i-layer 32, the n-layer 33, and the p-layer 41 are stacked on the substrate 1 in layers in accordance with the order of the film-formation reaction chambers.

In the exposure apparatus, the substrate 1 on which the aforementioned four layers are formed is exposed to an air atmosphere, the substrate 1 is transferred from the first film-formation apparatus to the second film-formation apparatus.

The exposure apparatus includes a roller transfer unit and a dustproof cover that is placed so as to cover the roller transfer unit.

Additionally, a control device that controls the length of time for transferring the substrate and a substrate holder may be provided in the exposure apparatus.

The substrate holder is used as a buffer temporarily holding the substrate.

In the exposure apparatus having the foregoing constitution, the substrate 1 on which the above-described four layers are formed is transferred on the roller transfer unit from the first film-formation apparatus toward the second film-formation apparatus.

Since the dustproof cover is provided at the exposure apparatus, dusts such as particles are prevented from being adhered on the substrate 1 in a step of transferring the substrate 1.

In the foregoing exposure apparatus, the speed of the substrate 1 being transferred by the roller transfer unit is controlled, and the length of time of the substrate 1 being subjected to an air atmosphere is thereby controlled.

In the second film-formation apparatus, the i-layer 42, the n-layer 43, and the p-layer 44A of the second photoelectric conversion unit 4 is stacked in layers in the same film-formation reaction chamber (single second plasma CVD reaction chamber) in this order.

Additionally, since a plurality of substrates are collectively transferred to the foregoing film-formation reaction chamber, the i-layer 42, the n-layer 43, and the p-layer 44A are sequentially formed on each of the substrates (batch processing).

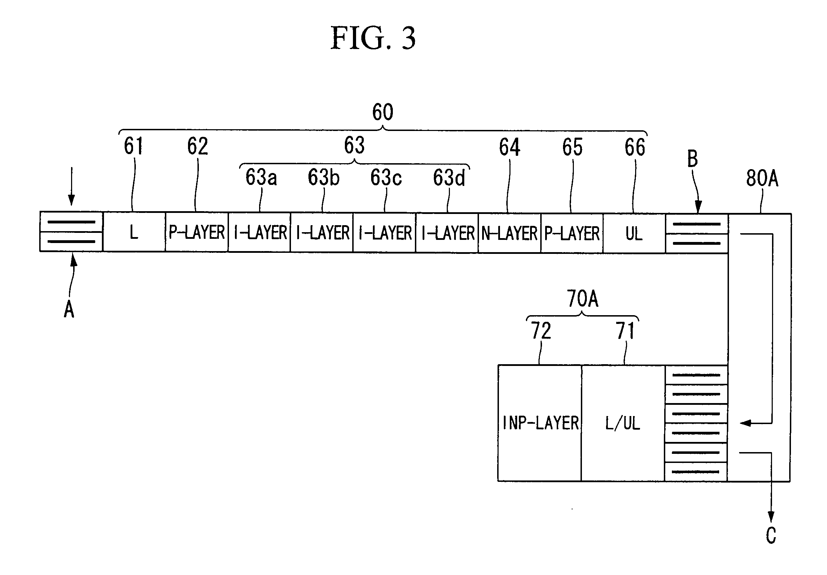

The photoelectric conversion device manufacturing system related to the invention is shown in FIG. 3.

As shown in FIG. 3, the manufacturing system is constituted of the first film-formation apparatus 60, the second film-formation apparatus 70A, and the exposure apparatus 80A.

In the exposure apparatus 80A, the substrate which was treated in the first film-formation apparatus 60 is exposed to an air atmosphere, thereafter, the substrate is transferred to the second film-formation apparatus 70A.

### First Film-formation Apparatus

In the first film-formation apparatus 60 of the manufacturing system, a load chamber 61 (L: Lord) to which the substrate is initially transferred and to which a vacuum pump reducing the internal pressure thereof is connected is disposed.

In other cases, a heating chamber in which the substrate is heated so as to cause the substrate temperature to reach a constant temperature may be provided at a stage subsequent to the load chamber 61 in accordance with a film formation process.

A P-layer film-formation reaction chamber 62 in which the p-layer 31 is formed is connected to the load chamber 61.

An I-layer film-formation reaction chamber 63 in which the i-layer 32 is formed is connected to the P-layer film-formation reaction chamber 62.

An N-layer film-formation reaction chamber 64 in which the n-layer 33 is formed is connected to the 1-layer film-formation reaction chamber 63.

A P-layer film-formation reaction chamber 65 in which the p-layer 41 of the second photoelectric conversion unit 4 is formed is connected to the N-layer film-formation reaction chamber 64.

An unload chamber 66 (UL: Unlord, discharge device), which returns the internal pressure thereof to an atmospheric pressure from a reduced-pressure and which transfers the substrate from the first film-formation apparatus 60, is connected to the P-layer film-formation reaction chamber 65.

A plurality of the above-described reaction chambers 62, 63, 64, and 65 are continuously and linearly arranged between the load chamber 61 and the unload chamber 66.

The substrate is sequentially transferred to the reaction chambers 62, 63, 64, and 65 in a state where a reduced-pressure atmosphere is maintained, and a film formation processing is performed in each reaction chamber.

The reaction chambers 62, 63, 64, and 65 are the above-described first plasma CVD reaction chambers.

Furthermore, a gas box (gas introduction unit) and a gas line (gas introduction unit) which supply the above-described gases to the reaction chambers 62, 63, 64, and 65 are provided in the first film-formation apparatus 60.

Additionally, a mass-flow controller (gas introduction unit) is connected to the reaction chambers 62, 63, 64, and 65, the flow rate of the gas that is supplied through the gas box and the gas line is controlled, and the gas having the controlled flow rate is supplied to the inside of the reaction chambers 62, 63, 64, and 65.

At the A point shown in FIG. 3, the insulative-transparent substrate 1 on which transparent-electroconductive film 2 is formed is prepared as shown in FIG. 1A.

Moreover, at the B point shown in FIG. 3, a first intermediate part 10a of the photoelectric conversion device in which the p-layer 31, the i-layer 32, and the n-layer 33 of the first photoelectric conversion unit 3, and the p-layer 41 are provided on the transparent-electroconductive film 2 as shown in FIG. 1B is disposed.

### Second Film-formation Apparatus

The second film-formation apparatus 70A of the manufacturing system has a load-unload chamber 71 (L/UL) and an IN-layer film-formation reaction chamber 72 which is connected to the load-unload chamber 71.

The IN-layer film-formation reaction chamber 72 is the above-described single second plasma CVD reaction chamber.

The load-unload chamber 71 includes a transfer device replacing a post-processed substrate which was subjected to a film formation processing in the IN-layer film-formation reaction chamber 72 with an unprocessed substrate which is not subjected to a film formation processing in the second plasma CVD reaction chamber.

In the load-unload chamber 71 having the foregoing constitution, a first intermediate part 10a (unprocessed substrate) of the photoelectric conversion device which was processed in the first film-formation apparatus 60 is transferred to the IN-layer film-formation reaction chamber 72.

Furthermore, the substrate 1 (post-processed substrate) on which the i-layer 42, the n-layer 43, and the p-layer 44A are formed in the IN-layer film-formation reaction chamber 72 is transferred from the IN-layer film-formation reaction chamber 72.

The load-unload chamber 71 reduces the internal pressure thereof after the substrate is transferred to the IN-layer film-formation reaction chamber 72 and returns the internal pressure thereof from the reduced-pressure to an atmospheric pressure when the substrate is transferred from the load-unload chamber 71.

Furthermore, a gas box (gas introduction unit) and a gas line (gas introduction unit) which supply the above-described gases to the IN-layer film-formation reaction chamber 72 are provided in the second film-formation apparatus 70A.

Additionally, a mass-flow controller (gas introduction unit) is connected to the IN-layer film-formation reaction chamber 72, the flow rate of the gas that is supplied through the gas box and the gas line is controlled, and the gas having the controlled flow rate is supplied to the inside of the IN-layer film-formation reaction chamber 72.

Furthermore, in a case where an OH radical plasma processing described below is performed in the IN-layer film-formation reaction chamber 72, a gas introduction unit supplying the gas used for the plasma processing to the IN-layer film-formation reaction chamber 72 as described below is provided.

In the IN-layer film-formation reaction chamber 72, the i-layer 42, the n-layer 43, and the p-layer 44A of the second photoelectric conversion unit 4 are stacked in layers in the same film-formation reaction chamber (single second plasma CVD reaction chamber) in this order.

Additionally, since a plurality of substrates are collectively transferred to the foregoing film-formation reaction chamber, the i-layer 42, the n-layer 43, and the p-layer 44A are sequentially formed on each of the substrates (batch processing).

For this reason, the film formation processing in the IN-layer film-formation reaction chamber 72 is performed with respect to a plurality of substrates at the same time.

At the C point shown in FIG. 3, a second intermediate part 10b of the photoelectric conversion device in which the second photoelectric conversion unit 4 is provided on the first photoelectric conversion unit 3 as shown in FIG. 1C is disposed.

Additionally, in the in-line type first film-formation apparatus 60 as shown in FIG. 3, a film formation processing is performed with respect to two substrates at the same time.

The I-layer film-formation reaction chamber 63 is constituted of four reaction chambers 63a, 63b, 63c, and 63d.

Moreover, in FIG. 3, in the batch type second film-formation apparatus 70A, a film formation processing is performed with respect to six substrates at the same time.

According to the above-described photoelectric conversion device manufacturing method, the p-layer 31, the i-layer 32, and the n-layer 33 of the first photoelectric conversion unit 3 serving as an amorphous photoelectric conversion device are formed in the first film-formation apparatus 60, and the p-layer of the second photoelectric conversion unit 4 serving as a crystalline photoelectric conversion device is formed on the n-layer 33.

Additionally, the i-layer 42, the n-layer 43, and the p-layer 44A of the second photoelectric conversion unit 4 are formed in the second film-formation apparatus 70A.

Because of this, it is possible to easily control the distribution of the crystallization rate in the i-layer 42 of the second photoelectric conversion unit 4.

Specifically, in the first embodiment, the p-layer 44A is formed on the n-layer 43 of the second photoelectric conversion unit 4 in the same film forming chamber, and it is possible to obtain a photoelectric conversion device 10 having excellent characteristics.

In addition, in the first embodiment, it is desirable that before forming of the i-layer 42, the p-layer 41 of the second photoelectric conversion unit 4 that was exposed to an air atmosphere be subjected to plasma including OH radical (OH radical plasma processing).

The OH radical plasma processing is performed when the i-layer 42 and the n-layer 43 which constitute the second photoelectric conversion unit 4 are formed on the p-layer 41 that was exposed to an air atmosphere.

Additionally, a gas introduction unit supplying the gas used for the OH radical plasma processing is provided at the apparatus in which the OH radical plasma processing is performed.

Because of this, the flow rate of the gas which is required for the OH radical plasma processing is controlled, and the gas having the controlled flow rate is supplied to the inside of the processing chamber.

As the OH radical plasma processing, a method is adopted in which a OH radical plasma processing chamber is preliminarily prepared, the substrate on which the p-layer 41 of the second photoelectric conversion unit 4 is formed is transferred to the plasma processing chamber, and the p-layer 41 is exposed to the plasma.

Additionally, after the OH radical plasma processing, the i-layer 42, the n-layer 43, and the p-layer 44A which constitute the second photoelectric conversion unit 4 are formed in the reaction chamber which is different from the OH radical plasma processing chamber.

On the other hand, as the OH radical plasma processing, the OH radical plasma processing (first processing) and the processing (second processing) of forming the i-layer 42, the n-layer 43, and the p-layer 44A of the second photoelectric conversion unit 4 may be continuously carried out in the same reaction chamber.

Here, in a case where the above-described first processing and the second processing are continuously performed in the same processing chamber, due to an inner wall of the reaction chamber being subjected to the plasma including OH radical for each processing, it is possible to decompose and remove an impurity gas PH₃ remaining in the reaction chamber.

For this reason, even where the film formation steps of forming the i-layer 42, the n-layer 43, and the p-layer 44A of the second photoelectric conversion unit 4 are repeatedly performed in the same-processing chamber, an excellent impurity profile is obtained, it is possible to obtain a photoelectric conversion device that is constituted of stacked thin films having an excellent power generation efficiency.

Additionally, in the OH radical plasma processing with respect to the p-layer 41 of the second photoelectric conversion unit 4, it is desirable that CO₂, CH₂O₂, or a mixed gas composed of H₂O and H₂ be used as a processing gas.

Namely, when the OH radical plasma is generated, by applying a high-frequency (e.g., 13.5 MHz, 27 MHz, 40 MHz, or the like) between electrodes in the processing chamber in a state where (CO₂ + H₂), (CH₂O₂ + H₂), or (H₂O + H₂) flows into the processing chamber, plasma can be effectively generated.

In the generation of plasma including the OH radical, alcohol such as (HCOOCH₃ + H₂), (CH₃0H + H₂), or the like, or, hydrocarbon including oxygen such as formic acid ester or the like may be used.

However, in the system having a problem in that the amount of impurities of C increases, it is preferable that (CO₂ + H₂), (CH₂O₂ + H₂), or (H₂O + H₂) be used.

When CO₂ is used as a gas used for generating plasma in the generation of the plasma including the OH radical, it is necessary for H₂ to exist in the system.

However, when alcohol such as (HCOOCH₃ + H₂), (CH₃OH + H₂), or the like, or hydrocarbon including oxygen such as formic acid ester or the like as well as (CH₂O₂ + H₂), (H₂O + H₂) is used, it is not necessary for H₂ to exist in a system.

When the OH radical plasma processing is performed in the above-described manner, reaction is stilly generated compared with the O radical processing.

Because of this, the n-layer 33 which is formed on the p-layer 31 and the i-layer 32 of the first photoelectric conversion unit 3 and in which a microcrystalline phase is dispersed in an amorphous crystal phase is obtained without damage to an under layer.

For this reason, the effect of the surface of the p-layer 41 formed on the n-layer 33 being activated is obtained.

Therefore, it is possible to activate the surface of the p-layer 41 of the second photoelectric conversion unit 4, and it is possible to effectively generate the crystal of the i-layer 42 and the n-layer 43 which are to be stacked in layers on the p-layer 41 of the second photoelectric conversion unit 4.

As a result, even where a second photoelectric conversion unit 4 is formed on a large-scaled substrate, it is possible to obtain uniform distribution of the crystallization rate.

Additionally, as a crystalline n-layer 33 and a p-layer 41 of the second photoelectric conversion unit 4, a layer in which microcrystalline silicon is dispersed in an amorphous silicon layer may be adopted.

Furthermore, a layer in which microcrystalline silicon is dispersed in an amorphous silicon oxide (a-SiO) layer may be adopted.

However, in order to obtain uniform distribution of the crystallization rate that is required for the film to be formed on a large-scaled substrate, that is, namely, in order to obtain uniform distribution of the crystallization rate due to generation of crystal growth core of an i-layer and an n-layer of a crystalline photoelectric conversion-layer, it is preferable that a layer be employed in which microcrystalline silicon is dispersed in an amorphous silicon oxide layer.

As described above, the layer in which microcrystalline silicon is dispersed in the amorphous silicon oxide layer can be adjusted so as to obtain a refractive index that is lower than that of a semiconductor layer of amorphous silicon.

It is possible for the layer to function as a wavelength-selective reflection film, and improve the conversion efficiency by confining short-wavelength light in a top cell side.

Additionally, irrespective of the presence or absence of an effect of the light being trapped, in the layer in which microcrystalline silicon is dispersed in the amorphous silicon oxide layer, a crystal growth core of the i-layer 42 and the n-layer 43 of the second-photoelectric conversion unit 4 is effectively generated by the OH radical plasma processing.

Because of this, even where a large-scaled substrate is used, it is possible to obtain uniform distribution of the crystallization rate.

In addition, a crystalline-silicon-based thin film may be formed as an n-layer 33 constituting an first-photoelectric conversion unit 3 in the invention.

That is, a crystalline n-layer 33 and the p-layer 41 of the crystalline second photoelectric conversion unit 4 are formed on the p-layer 31 and the i-layer 32 of an amorphous first photoelectric conversion unit 3.

At this time, it is desirable that the crystalline n-layer 33 and the p-layer 41 of the second photoelectric conversion unit 4 which are to be formed on the p-layer 31 and the i-layer 32 be continuously formed without being exposed to an air atmosphere after the p-layer 31 and the i-layer 32 are formed.

On the other hand, a method is known in which the first photoelectric conversion unit 3 is subjected to an air atmosphere after the p-layer 31, the i-layer 32, and the n-layer 33 of the first photoelectric conversion unit 3 are formed, thereafter, the p-layer 41, the i-layer 42, and the n-layer 43 of the second photoelectric conversion unit 4 are formed in the reaction chamber.

In this method, the i-layer 32 of the first-photoelectric conversion unit 3 is deteriorated and the element capability is degraded, due to the length of time of the for the substrate being subjected to an air atmosphere, due to a temperature, due to an atmosphere, or the like.

Because of this, in the first embodiment, after the p-layer 31 and the i-layer 32 of the first photoelectric conversion unit 3 are formed, the crystalline n-layer 33 and the p-layer 41 of the second photoelectric conversion unit 4 are continuously formed without being exposed to an air atmosphere.

As described above, in the individual reaction chamber, due to carrying out the OH radical plasma processing to the substrate on which the crystalline n-layer 33 and the p-layer 41 of the second photoelectric conversion unit 4 are formed, the surface of the p-layer 41 is activated, and a crystal core is generated.

Subsequently, by stacking the p-layer 41 on the i-layer 42 and the n-layer 43 of the crystalline second photoelectric conversion unit 4, it is possible to obtain a photoelectric conversion device which is formed of stacked thin films having an excellent power generation efficiency and which has uniform distribution of the crystallization rate on the large-area thereof.

Additionally, the foregoing OH radical plasma processing may be performed in the same reaction chamber as the reaction chamber in which the i-layer 42 is formed.

### Second Embodiment

Next, a second embodiment of the invention will be described.

In addition, in the explanation described below, identical symbols are used for the elements which are identical to those of the first embodiment, and the explanations thereof are omitted or simplified.

In the second embodiment, a constitution or a method which are different from the above-described first embodiment will be mainly described.

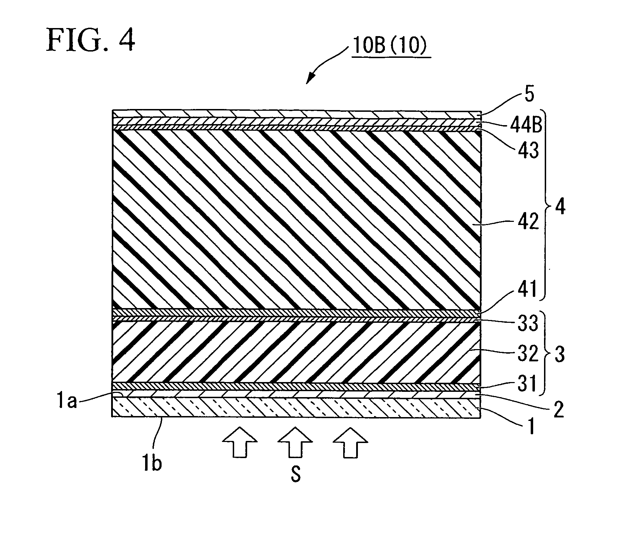

FIG. 4 is a cross-sectional view showing the layer structure of a photoelectric conversion device manufactured by a manufacturing method of a second embodiment.

In the second photoelectric conversion unit 4 of the photoelectric conversion device 10B (10), a p-type semiconductor layer 44B including oxygen (p-layer, third p-type semiconductor layer) is formed on the n-type semiconductor layer 43 (n-layer).

The p-layer 44B including oxygen is formed in the same reaction chamber as the reaction chamber in which the i-layer 42 and the n-layer 43 constituting the second photoelectric conversion unit 4 are formed.

At this time, a processing gas including a gas having an oxygen element is used.

The p-layer 44B including oxygen is formed of a silicon based material including a crystalline material.

Additionally, the thickness of the p-layer 44B including oxygen is, for example, 50Å.

The p-layer 44B is formed in the second film-formation apparatus 70A at which the oxygen-gas supply section is provided.

In the second film-formation apparatus 70A, a gas box (oxygen-gas supply section) and a gas line (oxygen-gas supply section) which supply the above-described gases to the IN-layer film-formation reaction chamber 72 is provided.

Additionally, a mass-flow controller (oxygen-gas supply section) is connected to the IN-layer film-formation reaction chamber 72, the flow rate of the gas (gas having an oxygen element) that is supplied through the gas box and the gas line is controlled, and the gas having the controlled flow rate is supplied to the inside of the IN-layer film-formation reaction chamber 72.

Therefore, since the oxygen-gas supply section is provided at the second film-formation apparatus 70A, it is possible to supply the processing gas including the gas having an oxygen element to the second film-formation apparatus 70A when the p-layer 44B is formed, and it is possible to form the p-layer 44B (p-type SiO layer) including oxygen.

As described above, the p-type SiO layer is formed on the n-layer 43.

Furthermore, the back-face electrode 5 is formed on the p-type SiO layer (refer to FIG. 4).

The thickness of the SiO layer is determined so as to obtain the conductivity between the n-layer 43 and the back-face electrode 5.

Moreover, the film thickness of the SiO layer may be non-uniform in between the n-layer 43 and the back-face electrode 5 and the SiO layer may be formed so that the n-layer 43 is directly and electrically connected to the back-face electrode 5.

In the method for forming the p-type SiO layer, in a state where (CO₂ + H₂), (CH₂O₂ + H₂), or (H₂O + H₂) in addition to (SiH₄/H₂/B₂H₆) flows in the film forming chamber, a high-frequency (e.g., 13.5 MHz, 27 MHz, 40 MHz, or the like) is applied between electrodes.

Because of this, plasma including the OH radical is generated, and it is thereby possible to form the p-type SiO layer.

In the step for generating the foregoing plasma including the OH radical, alcohol such as (HCOOCH₃ + H₂), (CH₃OH + H₂), or the like, or, hydrocarbon including oxygen such as formic acid ester or the like may be used.

However, in the system having a problem in that the amount of impurities of C increases, it is preferable that (CO₂ + H₂), (CH₂O₂ + H₂), or (H₂O + H₂) be used.

When CO₂ is used as a gas used for generating plasma in the generation of the plasma including the OH radical, it is necessary for H₂ to exist in the system.

However, when alcohol such as (HCOOCH₃ + H₂), (CH₃OH + H₂), or the like, or hydrocarbon including oxygen such as formic acid ester or the like as well as (CH₂O₂ + H₂), (H₂O + H₂) is used, it is not necessary for H₂ to exist in a system.

As described above, in the second embodiment, the p-layer 44B including oxygen is formed on the n-layer 43 of the second photoelectric conversion unit 4.

The p-layer 44B is formed in the same plasma CVD reaction chamber in which the i-type 42 and the n-layer 43 are formed.

In the plasma CVD reaction chamber, since the p-layer 44B is formed on the n-layer 43, a film including p-type impurities which are generated when the p-layer 44B is formed is adhered to the surface of the constituent elements which are disposed in the plasma CVD reaction chamber.

For this reason, the state where impurities which are generated in the manufacturing step of preliminarily manufacturing the second photoelectric conversion unit, that is, the state where the p-layer 44B is adhered to the surface of the constituent elements which are disposed in the plasma CVD reaction chamber is maintained.

In this state, at the time of initial growth in the i-layer 42 to be subsequently manufactured, p-type impurities which are generated along with formation of the p-layer 44B are only doped into the interface between the p-layer 41 and the i-layer 42.

When a layered structure formed by the p-layer 41 and the i-layer 42 of the second photoelectric conversion unit is formed, the p-type impurities expedite formation of a desired and normal p-i interface without inhibiting the junction state of a p-i interface.

Therefore, even where a step of transferring a substrate to or from the plasma CVD reaction chamber and a step of forming a film on the substrate in the plasma CVD reaction chamber are performed a plurality of times, that is, even where the number of the processed substrates or the number of batches in which a plurality of substrates are integrated increases, the characteristics of a photoelectric conversion device are not degraded.

Because of this, it is possible to stably manufacture a photoelectric conversion device 10B (10) having excellent efficiency, and the cost and the efficiency of manufacturing can be improved.

### Examples

Next, regarding the photoelectric conversion device which is manufactured using the photoelectric conversion device manufacturing method related to the invention, results of performing the following experiments will be described.

The photoelectric conversion device which is manufactured by each of Examples and the manufacturing conditions therefore will be shown as follows.

Examples 1 to 3 show results of using photoelectric conversion devices in which a p-type Si-layer serving as a p-layer was formed on an n-layer after forming of an i-layer and an n-layer of a second photoelectric conversion unit.

Additionally, in Examples 1 to 3, the photoelectric conversion devices were formed so as to make the film thicknesses of the p-type Si-layer thereof different.

In Examples 4 to 6, a p-type SiO layer serving as a p-layer including oxygen was formed on an n-layer the second photoelectric conversion unit.

Specifically, when the p-type SiO layer was formed, the p-type SiO layer was formed while flowing (CO₂ + H₂), (CH₂O₂ + H₂), or (H₂O + H₂) in addition to (SiH₄/H₂/B₂H₆) to a film forming chamber.

Specifically, (CO₂ + H₂) is used in Example 4, (CH₂O₂ + H₂) is used in Example 5, and (H₂O + H₂) is used in Example 5.

Additionally, in all of the photoelectric conversion devices in Examples 1 to 6, the photoelectric conversion devices were manufactured by use of a substrate having lengths of 1100 mm and 1400 mm.

### Example 1

The photoelectric conversion device manufacturing method of Example 1 will be described.

A p-layer composed of an amorphous-silicon based thin film, a buffer layer, an i-layer composed of an amorphous-silicon based thin film, an n-layer including microcrystalline silicon, which constitute a first photoelectric conversion unit, and a p-layer including microcrystalline silicon and constituting the second photoelectric conversion unit were sequentially formed on a substrate.

In the method for forming the above layers, a plurality of plasma CVD reaction chambers which are connected in line were used, one layer was formed in one plasma CVD reaction chamber using a plasma CVD method, and a plurality of layers were formed by carrying out a step of transferring a substrate and a step of forming a film on the substrate in order.

Subsequently, the p-layer constituting the second photoelectric conversion unit was subjected to an air atmosphere, and an OH radical included plasma processing was performed to the p-layer by use of (CO₂ + H₂) serving as a processing gas.

Thereafter, an i-layer and an n-layer which are composed of microcrystalline silicon and which constitute the second photoelectric conversion unit were formed, and a p-layer composed of microcrystalline silicon were formed on an n-layer.

The i-layer and the n-layer constituting the second photoelectric conversion unit and the p-layer which is formed on the n-layer of the second photoelectric conversion unit and is composed of microcrystalline silicon were formed in the same film forming chamber using a plasma CVD method.

The p-layer of the first-photoelectric conversion unit was formed so as to have a film thickness of 90 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), 180 sccm of diborane (B₂H₆/H₂) using hydrogen as a diluted gas, and 500 sccm of methane (CH₄).

In addition, the buffer layer was formed so as to have a film thickness of 60 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), and 100 sccm of methane (CH₄).

Furthermore, the i-layer of the first-photoelectric conversion unit was formed so as to have a film thickness of 2500 Å, under conditions in which the substrate temperature was 190°C, the frequency of the power source was 13.56 MHz, the internal pressure of the reaction chamber was 80 Pa, and the flow rate of the reactive gas was 1200 sccm of monosilane (SiH₄).

Additionally, the n-layer of the first-photoelectric conversion unit was formed so as to have a film thickness of 300 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Next, the p-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 100 sccm of monosilane (SiH₄), 25000 sccm of hydrogen (H₂), and 50 sccm of diborane (B₂H₆/H₂) using hydrogen as a diluted gas.

Additionally, the p-layer of the second photoelectric conversion unit was exposed to an air atmosphere.

Subsequently, the p-layer of the second photoelectric conversion unit was subjected to a plasma processing, under conditions in which the substrate temperature was 190°C, the frequency of the power source was 13.56 MHz, the internal pressure of the reaction chamber was 700 Pa, and the flow rates of the reactive gases were 1000 sccm of hydrogen (H₂) and 150 sccm of CO₂.

Continuously, the i-layer of the second photoelectric conversion unit was formed so as to have a film thickness of 15000 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄) and 27000 sccm of hydrogen (H₂).

Consequently, the n-layer of the second photoelectric conversion unit was formed so as to have a film thickness of 150 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Furthermore, the p-layer formed on the n-layer of the second photoelectric conversion unit was formed so as to have a film thickness of 30 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 20000 sccm of hydrogen (H₂), and 50 sccm of diborane (B₂H₆/H₂) using hydrogen as a diluted gas.

### Example 2

The photoelectric conversion device manufacturing method of Example 2 will be described.

A p-layer composed of an amorphous-silicon based thin film, a buffer layer, an i-layer composed of an amorphous-silicon based thin film, an n-layer including microcrystalline silicon, which constitute a first photoelectric conversion unit, and a p-layer including microcrystalline silicon and constituting the second photoelectric conversion unit were sequentially formed on a substrate.

In the method for forming the above layers, a plurality of plasma CVD reaction chambers which are connected in line were used, one layer was formed in one plasma CVD reaction chamber using a plasma CVD method, and a plurality of layers were formed by carrying out a step of transferring a substrate and a step of forming a film on the substrate in order.

Subsequently, the p-layer constituting the second photoelectric conversion unit was subjected to an air atmosphere, and an OH radical included plasma processing was performed to the p-layer by use of (CO₂ + H₂) serving as a processing gas.

Thereafter, an i-layer and an n-layer which are composed of microcrystalline silicon and which constitute the second photoelectric conversion unit were formed, and a p-layer composed of microcrystalline silicon were formed on an n-layer.

The i-layer and the n-layer constituting the second photoelectric conversion unit and the p-layer which is formed on the n-layer of the second photoelectric conversion unit and is composed of microcrystalline silicon were formed in the same film forming chamber using a plasma CVD method.

The p-layer of the first-photoelectric conversion unit was formed so as to have a film thickness of 90 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), 180 sccm of diborane (B₂H₆/H₂) using hydrogen as a diluted gas, and 500 sccm of methane (CH₄).

In addition, the buffer layer was formed so as to have a film thickness of 60 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), and 100 sccm of methane (CH₄).

Furthermore, the i-layer of the first-photoelectric conversion unit was formed so as to have a film thickness of 2500 Å, under conditions in which the substrate temperature was 190°C, the frequency of the power source was 13.56 MHz, the internal pressure of the reaction chamber was 80 Pa, and the flow rate of the reactive gas was 1200 sccm of monosilane (SiH₄).

Additionally, the n-layer of the first-photoelectric conversion unit was formed so as to have a film thickness of 300 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Next, the p-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 100 sccm of monosilane (SiH₄), 25000 sccm of hydrogen (H₂), and 50 sccm of diborane (B₂H₆/H₂) using hydrogen as a diluted gas.

Additionally, the p-layer of the second photoelectric conversion unit was exposed to an air atmosphere.

Subsequently, the p-layer of the second photoelectric conversion unit was subjected to a plasma processing, under conditions in which the substrate temperature was 190°C, the frequency of the power source was 13.56 MHz, the internal pressure of the reaction chamber was 700 Pa, and the flow rates of the reactive gases were 1000 sccm of hydrogen (H₂) and 150 sccm of CO₂.

Continuously, the i-layer of the second photoelectric conversion unit was formed so as to have a film thickness of 15000 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄) and 27000 sccm of hydrogen (H₂).

Consequently, the n-layer of the second photoelectric conversion unit was formed so as to have a film thickness of 150 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Furthermore, the p-layer formed on the n-layer of the second photoelectric conversion unit was formed so as to have a film thickness of 50 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 20000 sccm of hydrogen (H₂), and 50 sccm of diborane (B₂H₆/H₂) using hydrogen as a diluted gas.

### Example 3

The photoelectric conversion device manufacturing method of Example 3 will be described.

A p-layer composed of an amorphous-silicon based thin film, a buffer layer, an i-layer composed of an amorphous-silicon based thin film, an n-layer including microcrystalline silicon, which constitute a first photoelectric conversion unit, and a p-layer including microcrystalline silicon and constituting the second photoelectric conversion unit were sequentially formed on a substrate.

In the method for forming the above layers, a plurality of plasma CVD reaction chambers which are connected in line were used, one layer was formed in one plasma CVD reaction chamber using a plasma CVD method, and a plurality of layers were formed by carrying out a step of transferring a substrate and a step of forming a film on the substrate in order.

Subsequently, the p-layer constituting the second photoelectric conversion unit was subjected to an air atmosphere, and an OH radical included plasma processing was performed to the p-layer by use of (CO₂ + H₂) serving as a processing gas.

Thereafter, an i-layer and an n-layer which are composed of microcrystalline silicon and which constitute the second photoelectric conversion unit were formed, and a p-layer composed of microcrystalline silicon were formed on an n-layer.

The i-layer and the n-layer constituting the second photoelectric conversion unit and the p-layer which is formed on the n-layer of the second photoelectric conversion unit and is composed of microcrystalline silicon were formed in the same film forming chamber using a plasma CVD method.

The p-layer of the first-photoelectric conversion unit was formed so as to have a film thickness of 90 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), 180 sccm of diborane (B₂H₆/Hz) using hydrogen as a diluted gas, and 500 sccm of methane (CH₄).

In addition, the buffer layer was formed so as to have a film thickness of 60 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), and 100 sccm of methane (CH₄).

Furthermore, the i-layer of the first-photoelectric conversion unit was formed so as to have a film thickness of 2500 Å, under conditions in which the substrate temperature was 190°C, the frequency of the power source was 13.56 MHz, the internal pressure of the reaction chamber was 80 Pa, and the flow rate of the reactive gas was 1200 sccm of monosilane (SiH₄).

Additionally, the n-layer of the first-photoelectric conversion unit was formed so as to have a film thickness of 300 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Next, the p-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 100 sccm of monosilane (SiH₄), 25000 sccm of hydrogen (H₂), and 50 sccm of diborane (B₂H₆/H₂) using hydrogen as a diluted gas.

Additionally, the p-layer of the second photoelectric conversion unit was exposed to an air atmosphere.

Subsequently, the p-layer of the second photoelectric conversion unit was subjected to a plasma processing, under conditions in which the substrate temperature was 190°C, the frequency of the power source was 13.56 MHz, the internal pressure of the reaction chamber was 700 Pa, and the flow rates of the reactive gases were 1000 sccm of hydrogen (H₂) and 150 sccm of CO₂.

Continuously, the i-layer of the second photoelectric conversion unit was formed so as to have a film thickness of 15000 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄) and 27000 sccm of hydrogen (H₂).

Consequently, the n-layer of the second photoelectric conversion unit was formed so as to have a film thickness of 150 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Furthermore, the p-layer formed on the n-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 20000 sccm of hydrogen (H₂), and 50 sccm of diborane (B₂H₆/H₂) using hydrogen as a diluted gas.

### Example 4

The photoelectric conversion device manufacturing method of Example 4 will be described.

A p-layer composed of an amorphous-silicon based thin film, a buffer layer, an i-layer composed of an amorphous-silicon based thin film, an n-layer including microcrystalline silicon, which constitute a first photoelectric conversion unit, and a p-layer including microcrystalline silicon and constituting the second photoelectric conversion unit were sequentially formed on a substrate.

In the method for forming the above layers, a plurality of plasma CVD reaction chambers which are connected in line were used, one layer was formed in one plasma CVD reaction chamber using a plasma CVD method, and a plurality of layers were formed by carrying out a step of transferring a substrate and a step of forming a film on the substrate in order.

Subsequently, the p-layer constituting the second photoelectric conversion unit was subjected to an air atmosphere, and an OH radical included plasma processing was performed to the p-layer by use of (CO₂ + H₂) serving as a processing gas.

Thereafter, an i-layer and an n-layer which are composed of microcrystalline silicon and which constitute the second photoelectric conversion unit were formed, and a p-layer composed of microcrystalline silicon were formed on an n-layer.

The i-layer and the n-layer constituting the second photoelectric conversion unit and the p-layer which is formed on the n-layer of the second photoelectric conversion unit and which includes oxygen were formed in the same film forming chamber using a plasma CVD method.

The p-layer of the first-photoelectric conversion unit was formed so as to have a film thickness of 90 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), 180 sccm of diborane (B₂H₆/H₂) using hydrogen as a diluted gas, and 500 sccm of methane (CH₄).

In addition, the buffer layer was formed so as to have a film thickness of 60 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), and 100 sccm of methane (CH₄).

Furthermore, the i-layer of the first-photoelectric conversion unit was formed so as to have a film thickness of 2500 Å, under conditions in which the substrate temperature was 190°C, the frequency of the power source was 13.56 MHz, the internal pressure of the reaction chamber was 80 Pa, and the flow rate of the reactive gas was 1200 sccm of monosilane (SiH₄).

Additionally, the n-layer of the first-photoelectric conversion unit was formed so as to have a film thickness of 300 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Next, the p-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 100 sccm of monosilane (SiH₄), 25000 sccm of hydrogen (H₂), and 50 sccm of diborane (B₂H₆/H₂) using hydrogen as a diluted gas.

Additionally, the p-layer of the second photoelectric conversion unit was exposed to an air atmosphere.

Subsequently, the p-layer of the second photoelectric conversion unit was subjected to a plasma processing, under conditions in which the substrate temperature was 190°C, the frequency of the power source was 13.56 MHz, the internal pressure of the reaction chamber was 700 Pa, and the flow rates of the reactive gases were 1000 sccm of hydrogen (H₂) and 150 sccm of CO₂.

Continuously, the i-layer of the second photoelectric conversion unit was formed so as to have a film thickness of 15000 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄) and 27000 sccm of hydrogen (H₂).

Consequently, the n-layer of the second photoelectric conversion unit was formed so as to have a film thickness of 150 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Furthermore, the p-layer which is formed on the n-layer of the second photoelectric conversion unit and which includes oxygen was formed so as to have a film thickness of 50 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 20000 sccm of hydrogen (H₂), 50 sccm of diborane (B₂H₆/H₂) using hydrogen as a diluted gas, and 150 sccm of carbon dioxide (CO₂).

### Example 5

The photoelectric conversion device manufacturing method of Example 5 will be described.

A p-layer composed of an amorphous-silicon based thin film, a buffer layer, an i-layer composed of an amorphous-silicon based thin film, an n-layer including microcrystalline silicon, which constitute a first photoelectric conversion unit, and a p-layer including microcrystalline silicon and constituting the second photoelectric conversion unit were sequentially formed on a substrate.

In the method for forming the above layers, a plurality of plasma CVD reaction chambers which are connected in line were used, one layer was formed in one plasma CVD reaction chamber using a plasma CVD method, and a plurality of layers were formed by carrying out a step of transferring a substrate and a step of forming a film on the substrate in order.

Subsequently, the p-layer constituting the second photoelectric conversion unit was subjected to an air atmosphere, and an OH radical included plasma processing was performed to the p-layer by use of (CO₂ + H₂) serving as a processing gas.

Thereafter, an i-layer and an n-layer which are composed of microcrystalline silicon and which constitute the second photoelectric conversion unit were formed, and a p-layer composed of microcrystalline silicon were formed on an n-layer.

The i-layer and the n-layer constituting the second photoelectric conversion unit and the p-layer which is formed on the n-layer of the second photoelectric conversion unit and which includes oxygen were formed in the same film forming chamber using a plasma CVD method.

The p-layer of the first-photoelectric conversion unit was formed so as to have a film thickness of 90 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), 180 sccm of diborane (B₂H₆/H₂) using hydrogen as a diluted gas, and 500 sccm of methane (CH₄).

In addition, the buffer layer was formed so as to have a film thickness of 60 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), and 100 sccm of methane (CH₄).

Furthermore, the i-layer of the first-photoelectric conversion unit was formed so as to have a film thickness of 2500 Å, under conditions in which the substrate temperature was 190°C, the frequency of the power source was 13.56 MHz, the internal pressure of the reaction chamber was 80 Pa, and the flow rate of the reactive gas was 1200 sccm of monosilane (SiH₄).

Additionally, the n-layer of the first-photoelectric conversion unit was formed so as to have a film thickness of 300 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Next, the p-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 100 sccm of monosilane (SiH₄), 25000 sccm of hydrogen (H₂), and 50 sccm of diborane (B₂H₆/H₂) using hydrogen as a diluted gas.

Additionally, the p-layer of the second photoelectric conversion unit was exposed to an air atmosphere.

Subsequently, the p-layer of the second photoelectric conversion unit was subjected to a plasma processing, under conditions in which the substrate temperature was 190°C, the frequency of the power source was 13.56 MHz, the internal pressure of the reaction chamber was 700 Pa, and the flow rates of the reactive gases were 1000 sccm of hydrogen (H₂) and 150 sccm of CO₂.

Continuously, the i-layer of the second photoelectric conversion unit was formed so as to have a film thickness of 15000 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄) and 27000 sccm of hydrogen (H₂).

Consequently, the n-layer of the second photoelectric conversion unit was formed so as to have a film thickness of 150 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Furthermore, the p-layer which is formed on the n-layer of the second photoelectric conversion unit and which includes oxygen was formed so as to have a film thickness of 50 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 20000 sccm of hydrogen (H₂), 50 sccm of diborane (B₂H₆/H₂) using hydrogen as a diluted gas, and 250 sccm of formic acid (CH₂O₂).

### Example 6

The photoelectric conversion device manufacturing method of Example 6 will be described.

A p-layer composed of an amorphous-silicon based thin film, a buffer layer, an i-layer composed of an amorphous-silicon based thin film, an n-layer including microcrystalline silicon, which constitute a first photoelectric conversion unit, and a p-layer including microcrystalline silicon and constituting the second photoelectric conversion unit were sequentially formed on a substrate.

In the method for forming the above layers, a plurality of plasma CVD reaction chambers which are connected in line were used, one layer was formed in one plasma CVD reaction chamber using a plasma CVD method, and a plurality of layers were formed by carrying out a step of transferring a substrate and a step of forming a film on the substrate in order.

Subsequently, the p-layer constituting the second photoelectric conversion unit was subjected to an air atmosphere, and an OH radical included plasma processing was performed to the p-layer by use of (CO₂ + H₂) serving as a processing gas.

Thereafter, an i-layer and an n-layer which are composed of microcrystalline silicon and which constitute the second photoelectric conversion unit were formed, and a p-layer composed of microcrystalline silicon were formed on an n-layer.

The i-layer and the n-layer constituting the second photoelectric conversion unit and the p-layer which is formed on the n-layer of the second photoelectric conversion unit and which includes oxygen were formed in the same film forming chamber using a plasma CVD method.

The p-layer of the first-photoelectric conversion unit was formed so as to have a film thickness of 90 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), 180 sccm of diborane (B₂H₆/H₂) using hydrogen as a diluted gas, and 500 sccm of methane (CH₄).

In addition, the buffer layer was formed so as to have a film thickness of 60 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), and 100 sccm of methane (CH₄).

Furthermore, the i-layer of the first-photoelectric conversion unit was formed so as to have a film thickness of 2500 Å, under conditions in which the substrate temperature was 190°C, the frequency of the power source was 13.56 MHz, the internal pressure of the reaction chamber was 80 Pa, and the flow rate of the reactive gas was 1200 sccm of monosilane (SiH₄).

Additionally, the n-layer of the first-photoelectric conversion unit was formed so as to have a film thickness of 300 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Next, the p-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 100 sccm of monosilane (SiH₄), 25000 sccm of hydrogen (H₂), and 50 sccm of diborane (B₂H₆/H₂) using hydrogen as a diluted gas.

Additionally, the p-layer of the second photoelectric conversion unit was exposed to an air atmosphere.

Subsequently, the p-layer of the second photoelectric conversion unit was subjected to a plasma processing, under conditions in which the substrate temperature was 190°C, the frequency of the power source was 13.56 MHz, the internal pressure of the reaction chamber was 700 Pa, and the flow rates of the reactive gases were 1000 sccm of hydrogen (H₂) and 150 sccm of CO₂.

Continuously, the i-layer of the second photoelectric conversion unit was formed so as to have a film thickness of 15000 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄) and 27000 sccm of hydrogen (H₂).

Consequently, the n-layer of the second photoelectric conversion unit was formed so as to have a film thickness of 150 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Furthermore, the p-layer which is formed on the n-layer of the second photoelectric conversion unit and which includes oxygen was formed so as to have a film thickness of 50 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 20000 sccm of hydrogen (H₂), 50 sccm of diborane (B₂H₆/H₂) using hydrogen as a diluted gas, and 150 sccm of water (H₂O)

As described above, in Examples 1 to 6, the p-layer (additional p-layer) was formed on the n-layer constituting the second photoelectric conversion unit.

### Comparative Example

The photoelectric conversion device manufacturing method of Comparative Example will be described.

A p-layer composed of an amorphous-silicon based thin film, a buffer layer, an i-layer composed of an amorphous-silicon based thin film, an n-layer including microcrystalline silicon, which constitute a first photoelectric conversion unit, and a p-layer including microcrystalline silicon and constituting the second photoelectric conversion unit were sequentially formed on a substrate.

In the method for forming the above layers, a plurality of plasma CVD reaction chambers which are connected in line were used, one layer was formed in one plasma CVD reaction chamber using a plasma CVD method, and a plurality of layers were formed by carrying out a step of transferring a substrate and a step of forming a film on the substrate in order.

Subsequently, the p-layer constituting the second photoelectric conversion unit was subjected to an air atmosphere, and an OH radical included plasma processing was performed to the p-layer by use of (CO₂ + H₂) serving as a processing gas.

Thereafter, an i-layer and an n-layer which are composed of microcrystalline silicon and which constitute the second photoelectric conversion unit were formed.

The i-layer and the n-layer constituting the second photoelectric conversion unit were formed in the same film forming chamber using a plasma CVD method.

The p-layer of the first-photoelectric conversion unit was formed so as to have a film thickness of 90 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), 180 sccm of diborane (B₂H₆/H₂) using hydrogen as a diluted gas, and 500 sccm of methane (CH₄).

In addition, the buffer layer was formed so as to have a film thickness of 60 Å, under conditions in which the substrate temperature was 190°C, the frequency of the power source was 13.56 MHz, the internal pressure of the reaction chamber was 110 Pa, and the flow rates of the reactive gases were 300 sccm of monosilane (SiH₄), 2300 sccm of hydrogen (H₂), and 100 sccm of methane (CH₄).

Furthermore, the i-layer of the first-photoelectric conversion unit was formed so as to have a film thickness of 2500 Å, under conditions in which the substrate temperature was 190°C, the frequency of the power source was 13.56 MHz, the internal pressure of the reaction chamber was 80 Pa, and the flow rate of the reactive gas was 1200 sccm of monosilane (SiH₄).

Additionally, the n-layer of the first-photoelectric conversion unit was formed so as to have a film thickness of 300 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

Next, the p-layer of the second photoelectric conversion unit was formed so as to have a film thickness of 100 Å, under conditions in which the substrate temperature was 180°C, the frequency of the power source was 13.56 MHz, the internal pressure of the reaction chamber was 700 Pa, and the flow rates of the reactive gases were 100 sccm of monosilane (SiH₄), 25000 sccm of hydrogen (H₂), and 50 sccm of diborane (B₂H₆/H₂) using hydrogen as a diluted gas.

Additionally, the p-layer of the second photoelectric conversion unit was exposed to an air atmosphere.

Subsequently, the p-layer of the second photoelectric conversion unit was subjected to a plasma processing, under conditions in which the substrate temperature was 190°C, the frequency of the power source was 13.56 MHz, the internal pressure of the reaction chamber was 700 Pa, and the flow rates of the reactive gases were 1000 sccm of hydrogen (H₂) and 150 sccm of CO₂.

Continuously, the i-layer of the second photoelectric conversion unit was formed so as to have a film thickness of 15000 To, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄) and 27000 sccm of hydrogen (H₂).

Consequently, the n-layer of the second photoelectric conversion unit was formed so as to have a film thickness of 150 Å, under conditions in which the substrate temperature was 180°C, the frequency of the power source was 13.56 MHz, the internal pressure of the reaction chamber was 700 Pa, and the flow rates of the reactive gases were 180 sccm of monosilane (SiH₄), 27000 sccm of hydrogen (H₂), and 200 sccm of phosphine (PH₃/H₂) using hydrogen as a diluted gas.

In the foregoing Comparative Example, the p-layer (additional p-layer) was not formed on the n-layer constituting the second photoelectric conversion unit.

Next, experimental results evaluating the above-described photoelectric conversion device of Examples 1 to 6 and the photoelectric conversion device of the Comparative Example are shown in Table 1.

In this experiment, the photoelectric conversion device which was initially manufactured at the time of starting the manufacturing therefor in a film-formation apparatus (initially manufactured photoelectric conversion device) is compared to the photoelectric conversion device which was obtained after film formation batch processings have been continuously performed 100 times in the film-formation apparatus (photoelectric conversion device due to 100 times of film formation batch processing).

Here, the film formation batch processing means the transferring of one batch in which a plurality of substrates are integrated to a plasma CVD reaction chamber and thereafter performing a film formation processing to the substrates constituting the batch.

As described above, output characteristics were measured at 25°C while irradiating, with light of AM1.5 by amount of light of 100mW/cm², the photoelectric conversion device which was initially manufactured and the photoelectric conversion device which was subjected to the film formation batch processing 100 times.

Additionally, as the output characteristics, the fill factor (FF) and the conversion efficiency (Eff) were measured.

The measurement results are shown in Table 1.

In Table 1, a amorphous photoelectric conversion layer is represented by "p", "I", and "n" and, a crystalline photoelectric conversion layer is represented by "P", "I", and "N".

Furthermore, in Table 1, the types of processing gas used in the OH radical included plasma processing are represented by (CO₂ + H₂), (CH₂O₂ + H₂), and (H₂O + H₂).

**Table 1**

| | ELENENT STRUCTURE | PRESENCE OR ABSENCE OF ADDITIONAL P-LAYER | FILM FORMING CONDITIONS OF ADDITIONAL P-LAYER PLAYER | | VALUE OF INITIAL MANUFACTURE | | AFTER 100 TIMES OF FILM FORMATION BATCH PROCESSlNGS | |
|---|---|---|---|---|---|---|---|---|
| | | | ATMOSPHERE | FILM THICKNESS (Å) | FF | Eff (%) | FF | Eff (%) |
| EXAMPLE 1 | piNP//INP | PRESENCE | H₂ | 30 | 0.739 | 11. 07 | 0.733 | 11. 05 |
| EXAMPLE 2 | piNP//INP | PRESENCE | H₂ | 50 | 0.736 | 11.07 | 0.733 | 11.05 |
| EXAMPLE 3 | piNP//INP | PRESENCE | H₂ | 100 | 0.725 | 10.06 | 0.721 | 10.05 |
| EXAMPLE 4 | piNP//INP | PRESENCE | CO₂+H₂ | 50 | 0.737 | 12.52 | 0.733 | 12.50 |
| EXAMPLE 5 | piNP//INP | PRESENCE | GH₂O₂+H₂ | 50 | 0.733 | 10.05 | 0.730 | 10. 05 |
| EXAMPLE 6 | piNP//INP | PRESENCE | H₂O+H₂ | 50 | 0.732 | 11.02 | 0.727 | 11. 00 |
| COMPARATIVE EXAMPLE | piNP//IN | ABSENCE | - | - | 0.532 | 6. 23 | 0.426 | 4. 15 |

As apparent from Table 1, it is seen that all of the photoelectric conversion devices of Examples 1 to 6 and the Comparative Example have excellent characteristics at the start of manufacture.

In contrast, it is seen that, in the photoelectric conversion devices which were obtained after the film formation batch processings have been performed 100 times, the output characteristics of Examples 1 to 6 are significantly different from the output characteristics of the Comparative Example.

In Comparative Example in which the additional p-layer is not formed on the n-layer constituting the second photoelectric conversion unit, the fill factor thereof and the conversion efficiency of the photoelectric conversion device which was obtained after the film formation batch processings have been performed 100 times are significantly degraded compared with the initially manufactured photoelectric conversion device.

It is thought that, this is because n-type impurities are adhered to and accumulated inside of the reaction chamber with an increase in the number of the processed substrates in the case where the i-layer and the n-layer constituting the second photoelectric conversion unit are formed in the same plasma CVD reaction chamber.

That is, it is believed that, n-type impurities that are generated in the manufacturing step of preliminarily manufacturing the second photoelectric conversion unit doped into the i-layer constituting the second photoelectric conversion unit to be subsequently manufactured in the same film forming chamber at the time of initial growth thereof.

In this case, it is thought that an interfacial state between the p-layer and the i-layer constituting the second photoelectric conversion unit to be subsequently manufactured is different from a desired interfacial state, and it is thereby difficult to produce a layered structure formed by the p-layer and the i-layer.

It is believed that, as a result, the output characteristics of the photoelectric conversion device of the Comparative Example are significantly degraded.

In contrast, in Examples 1 to 6 in which the additional p-layer was formed on the n-layer constituting the second photoelectric conversion unit and in Examples 4 to 6 in which the p-layer including oxygen serving as an additional p-layer was formed, even after the film formation batch processings were performed 100 times, degradation of the fill factor and the conversion efficiency thereof are reduced.

For this reason, a photoelectric conversion device is obtained which has excellent output characteristics which are substantially similar to that of initial manufacturing.

This is because, since a p-layer or a p-layer including oxygen are additionally formed on the n-layer of the second photoelectric conversion unit, p-type impurities (p-layer) which are generated in the manufacturing step of preliminarily manufacturing the second photoelectric conversion unit are adhered to the surface of the constituent elements which are disposed in the film forming chamber.

As a result, at the time of initially forming the subsequently manufactured i-layer constituting the second photoelectric conversion unit in the same film forming chamber, p-type impurities which are generated when the additional p-layer is formed are only doped into the interface between the p-layer and the i-layer which constitute the second photoelectric conversion unit.

It is thought that, when a layered structure formed by the p-layer and the i-layer of the second photoelectric conversion unit which is to be subsequently manufactured, the p-type impurities expedite formation of a desired and normal p-i interface without inhibiting the junction state of a p-i interface.

It is thought that, as a result, degradation of the characteristics of the resultant photoelectric conversion device is prevented.

Additionally, comparing Examples 1 to 3 to each other in which the thicknesses of the additional p-layer are varied, regardless of the thickness of the p-layer, the above-described effect is obtained that it is possible to prevent the characteristics of a photoelectric conversion device from being degraded, but, it is seen that an excellent result is particularly obtained in the case where the thickness thereof is less than 100 Å.

### Industrial Applicability

The present invention is widely applicable to a tandem-type photoelectric conversion device manufacturing method and photoelectric conversion device manufacturing system.

## Claims

1. A photoelectric conversion device manufacturing method in which a first p-type semiconductor layer, a first i-type semiconductor layer, and a first n-type semiconductor layer, which constitute a first photoelectric conversion unit, and a second p-type semiconductor layer, a second i-type semiconductor layer, and a second n-type semiconductor layer, which constitute a second photoelectric conversion unit made of a crystalline-silicon-based thin film, are sequentially stacked in layers on a transparent-electroconductive film formed on a substrate, by use of a plurality of first plasma CVD reaction chambers and a single second plasma CVD reaction chamber, the method comprising:
forming each of the first p-type semiconductor layer, the first i-type semiconductor layer, the first n-type semiconductor layer, and the second p-type semiconductor layer in a plurality of the first plasma CVD reaction chambers;
exposing the second p-type semiconductor layer to an air atmosphere;
supplying a gas including p-type impurities to inside the second plasma CVD reaction chamber before forming of the second i-type semiconductor layer;
forming the second i-type semiconductor layer on the second p-type semiconductor layer that was exposed to an air atmosphere, in the second plasma CVD reaction chamber; and
forming the second n-type semiconductor layer on the second i-type semiconductor layer.

2. The photoelectric conversion device manufacturing method according to claim 1, further comprising forming a third p-type semiconductor layer on the second n-type semiconductor layer in the second plasma CVD reaction chamber.

3. The photoelectric conversion device manufacturing method according to claim 2, wherein
the third p-type semiconductor layer includes oxygen.

4. The photoelectric conversion device manufacturing method according to claim 3, wherein
the third p-type semiconductor layer is formed using a processing gas including a gas having an oxygen element.

5. A photoelectric conversion device manufactured using the photoelectric conversion device manufacturing method according to any one of claims 1 to 4.

6. A photoelectric conversion device manufacturing system, the system manufacturing a photoelectric conversion device in which a first p-type semiconductor layer, a first i-type semiconductor layer, and a first n-type semiconductor layer, which constitute a first photoelectric conversion unit, and a second p-type semiconductor layer, a second i-type semiconductor layer, and a second n-type semiconductor layer, which constitute a second photoelectric conversion unit made of a crystalline-silicon-based thin film, are sequentially stacked in layers on a transparent-electroconductive film formed on a substrate, the system comprising:
a first film-formation apparatus including a plurality of first plasma CVD reaction chambers and forming each of the first p-type semiconductor layer, the first i-type semiconductor layer, the first n-type semiconductor layer, and the second p-type semiconductor layer in the first plasma CVD reaction chambers;
an exposure apparatus exposing the second p-type semiconductor layer to an air atmosphere; and
a second film-formation apparatus including a single second plasma CVD reaction chamber, supplying a gas including p-type impurities to the second plasma CVD reaction chamber before forming of the second i-type semiconductor layer, and forming the second i-type semiconductor layer on the second p-type semiconductor layer that was exposed to an air atmosphere and forming the n-type semiconductor layer on the second i-type semiconductor layer in the second plasma CVD reaction chamber.

7. The photoelectric conversion device manufacturing system according to claim 6, wherein
a third p-type semiconductor layer is formed on the second n-type semiconductor layer in the second plasma CVD reaction chamber.

8. The photoelectric conversion device manufacturing system according to claim 7, wherein
the third p-type semiconductor layer includes oxygen.

9. The photoelectric conversion device manufacturing system according to any one of claims 6 to 8, wherein
the second film-formation apparatus includes an oxygen-gas supply section supplying a processing gas including a gas having an oxygen element to the second plasma CVD reaction chamber.

10. A method for using a photoelectric conversion device manufacturing system, the system continuously manufacturing photoelectric conversion devices in which a plurality of semiconductor layers including a first-conductivity type semiconductor layer and a second-conductivity type semiconductor layer are stacked in layers on a transparent-electroconductive film formed on a substrate, the method comprising:
preparing a first film-formation apparatus including a first plasma CVD reaction chamber in which a first-conductivity type semiconductor layer is formed;
preparing an exposure apparatus connected to the first film-formation apparatus, exposing the first-conductivity type semiconductor layer formed by the first film-formation apparatus to an air atmosphere;
preparing a second film-formation apparatus including a second plasma CVD reaction chamber forming a semiconductor layer different from a first-conductivity type semiconductor layer on the first-conductivity type semiconductor layer that was exposed to an air atmosphere, and the second film-formation apparatus including a transfer device replacing a post-processed substrate on which a plurality of the semiconductor layers are stacked in layers in the second plasma CVD reaction chamber with an unprocessed substrate which is not yet subjected to a film formation processing in the second plasma CVD reaction chamber;
supplying a first impurity gas having first conductivity type impurities included in the first-conductivity type semiconductor layer that is exposed to an air atmosphere to the second plasma CVD reaction chamber after the second-conductivity type semiconductor layer is formed in the second plasma CVD reaction chamber and before the unprocessed substrate is transferred to the second plasma CVD reaction chamber;
evacuating the first impurity gas from the second plasma CVD reaction chamber after the first impurity gas is supplied to the second plasma CVD reaction chamber;
supplying a gas different from the first impurity gas to the second plasma CVD reaction chamber; and
forming a semiconductor layer different from the first-conductivity type semiconductor layer.

11. The method for using a photoelectric conversion device manufacturing system according to claim 10, wherein
the first-conductivity type semiconductor layer is a p-type semiconductor layer including p-type impurities;
the second-conductivity type semiconductor layer is an n-type semiconductor layer including n-type impurities;
a plurality of semiconductor layers are constituted of a p-type semiconductor layer, an i-type semiconductor layer, and an n-type semiconductor layer;
the first impurity gas is a gas including p-type impurities; and
the semiconductor layer different from the first-conductivity type semiconductor layer is an i-type semiconductor layer or an n-type semiconductor layer.

12. The method for using a photoelectric conversion device manufacturing system according to claim 10, wherein
when the first impurity gas is supplied to the second plasma CVD reaction chamber, plasma of the first impurity gas is generated in the second plasma CVD reaction chamber.
